(19) Europäisches Patentamt
European Patent Office
Office européen des brevets

(11) Veröffentlichungsnummer : **0 510 443 B1**

# (12) EUROPÄISCHE PATENTSCHRIFT

(45) Veröffentlichungstag der Patentschrift :
**22.03.95 Patentblatt 95/12**

(51) Int. Cl.[6] : **G03F 7/038**

(21) Anmeldenummer : **92106139.6**

(22) Anmeldetag : **09.04.92**

## (54) Negativ arbeitendes strahlungsempfindliches Gemisch und damit hergestelltes strahlungsempfindliches Aufzeichnungsmaterial.

(30) Priorität : **20.04.91 DE 4112965**

(43) Veröffentlichungstag der Anmeldung :
**28.10.92 Patentblatt 92/44**

(45) Bekanntmachung des Hinweises auf die Patenterteilung :
**22.03.95 Patentblatt 95/12**

(84) Benannte Vertragsstaaten :
**DE FR GB**

(56) Entgegenhaltungen :
**EP-A- 0 302 019**
**DE-A- 1 447 913**
**US-A- 4 376 818**

(73) Patentinhaber : **HOECHST AKTIENGESELLSCHAFT**
**D-65926 Frankfurt (DE)**

(72) Erfinder : **Lohaus, Gerhard, Dr.**
**Uhlandstrasse 4**
**W-6233 Klekheim (DE)**
Erfinder : **Spiess, Walter, Dr.**
**Rheingaustrasse 20**
**W-6110 Dieburg (DE)**
Erfinder : **Pawlowski, Georg, Dr.**
**Fritz-Kalle-Strasse 34**
**W-6200 Wiesbaden (DE)**

EP 0 510 443 B1

Anmerkung : Innerhalb von neun Monaten nach der Bekanntmachung des Hinweises auf die Erteilung des europäischen Patents kann jedermann beim Europäischen Patentamt gegen das erteilte europäische Patent Einspruch einlegen. Der Einspruch ist schriftlich einzureichen und zu begründen. Er gilt erst als eingelegt, wenn die Einspruchsgebühr entrichtet worden ist (Art. 99(1) Europäisches Patentübereinkommen).

Jouve, 18, rue Saint-Denis, 75001 PARIS

## Beschreibung

Die Erfindung betrifft ein negativ arbeitendes strahlungsempfindliches Gemisch mit

a) einer Verbindung, die unter Einwirkung von aktinischer Strahlung eine starke Säure bildet,

b) einer Verbindung mit mindestens zwei durch Säure vernetzbaren Gruppen und

c) einem in Wasser unlöslichen, in wäßrig-alkalischen Lösungen löslichen oder zumindest guellbaren polymeren Bindemittel.

Die Erfindung betrifft weiterhin ein damit hergestelltes strahlungsempfindliches Aufzeichnungsmaterial, das zur Herstellung von Photoresists, elektronischen Bauteilen, Druckplatten oder zum Formteilätzen geeignet ist.

Zur Herstellung mikroelektronischer Schaltungen finden derzeit mehrere lithographische Techniken Anwendung. Mit der g-line-Lithographie (436 nm), die üblicherweise auf konventionelle Diazonaphthochinon/Novolak-Formulierungen angewendet wird, können Resistbilder mit einer Auflösung von bis zu 0,8 µm hergestellt werden. Noch feinere Strukturen (bis herab zu 0,5 µm) lassen sich mit Hilfe der i-Line-Lithographie (365 nm) auf einer Resistschicht abbilden. Neuere Modifikationen der i-line-Lithographie, wie beispielsweise die Phase-Shifting-Mask-Technologie erlauben eine weitere Verkleinerung der abzubildenden Strukturen bis herab zu etwa 0,35 µm oder kleiner. Eine noch höhere Auflösung läßt sich mit UV2-Photoresists erreichen. Dabei werden zwei Bestrahlungstechniken eingesetzt: die UV2-Breitbandbelichtung (240 bis 260 nm) oder die Belichtung mit KrF-Excimer-Lasern, die bei 248 nm emittieren.

Die stetige Verkleinerung der Strukturen, beispielsweise in der Chip-Herstellung bis in den Bereich von weniger als 1 µm, erfordert veränderte lithographische Techniken. Um solche feinen Strukturen abzubilden, verwendet man Strahlung mit einer kurzen Wellenlänge, wie energiereiches UV-Licht, Elektronen- und Röntgenstrahlen. Das strahlungsempfindliche Gemisch muß an die kurzwellige Strahlung angepaßt sein. Eine Zusammenstellung der an das strahlungsempfindliche Gemisch gestellten Forderungen ist in dem Aufsatz von C.G. Willson "Organic Resist Materials - Theory and Chemistry" [Introduction to Microlithography, Theory, Materials, and Processing, Herausgeber L.F. Thompson, C.G. Willson, M.J. Bowden, ACS Symp. Ser., 219, 87 (1983), American Chemical Society, Washington] angegeben. Es bestand daher ein verstärkter Bedarf an strahlungsempfindlichen Gemischen, die in den neueren Technologien, wie der Mid- oder Deep-UV-Lithographie, [Belichtung z. B. mit Excimer-Lasern bei Wellenlängen von 305 nm (XeF), 248 nm (KrF), 193 nm (ArF)], der Elektronen- oder der Röntgenstrahl-Lithographie, einsetzbar sind, vorzugsweise darüber hinaus in einem weiten Spektralbereich empfindlich sind und dementsprechend auch in der konventionellen UV-Lithographie verwendet werden können.

Negativ arbeitende strahlungsempfindliche Gemische, die Bisazide als Vernetzer und von Isopren abgeleitete Bindemittel enthalten, sind bekannt. Sie werden als strahlungsempfindliche Schichten bei der Herstellung von Druckplatten, gedruckten Schaltungen und integrierten Schaltkreisen verwendet. Ihr Einsatz in der Mikrolithographie ist jedoch durch verschiedene technische Nachteile teile begrenzt. So ist es schwierig, qualitativ hochwertige Schichten ohne Fehlstellen (pin-holes) herzustellen. Der Wärmestand solcher Mischungen ist unzureichend, d. h. die Resistbilder werden bei der Verarbeitung durch thermischen Fluß verzerrt. Schließlich ist ihr Auflösungsvermögen auf Strukturen > 2 µm begrenzt, da sie bei der notwendigen Entwicklung mit organischen Lösemitteln auch in den gehärteten Bereichen unerwünscht hohe Quellung zeigen, was wiederum zu Strukturverzerrungen oder inhomogenen Entwicklungsprozessen und damit zu ungenauer Wiedergabe des durch die Belichtungsmaske vorgegebenen Bildes führt. Um Resistbilder mit einer Auflösung von besser als 2 µm herstellen zu können, sind andere negativ arbeitende strahlungsempfindliche Gemische entwickelt worden, die empfindlich gegenüber Strahlung kürzerer Wellenlänge sind, beispielsweise gegenüber energiereicher UV-, Elektronen oder Röntgenstrahlung. Ein derartiges Gemisch enthält beispielsweise ein Copolymer aus (2,3-Epoxy-propyl)-methacrylat und (2,3-Dichlor-propyl)methacrylat (DCOPA) oder eine Kombination der entsprechenden Homopolymeren. Die Glasübergangstemperatur dieses Gemisches ist jedoch für viele Anwendungen zu niedrig, insbesondere ist aber die geringe Plasmaätzbeständigkeit des Gemisches zu bemängeln. Darüber hinaus muß auch dieses Resistmaterial mit Entwicklern auf der Basis von wenig umweltfreundlichen, organischen Lösemitteln verarbeitet werden. Eine geringe Plasmaätzbeständigkeit zeigen auch andere bisher bekannte negativ arbeitende Photoresists auf aliphatischer Basis.

In der EP-A 0 164 248 wurde ein säurehärtbares Gemisch beschrieben, das wäßrig-alkalisch entwickelbar ist, durch die Verwendung von Aromaten eine verbesserte Plasmaätzresistenz aufweist und gegenüber nahem UV-Licht (350 bis 450 nm) empfindlich ist. Als Säurebildner sind dabei insbesondere Sulfonsäureesterderivate des Diazonaphthochinons genannt worden, die bei der Belichtung schwach saure Carbonsäuren bilden und daher nur in vergleichsweise hoher Konzentration wirksam sind. Solche Gemische haben aber infolge der schwachen Absorptionen und des unzureichenden Ausbleichverhaltens des photolytischen Säurebildners eine geringe Empfindlichkeit für DUV-, Elektronen- und Röntgenstrahlung.

In der US-A 3 692 560 wird ein säurehärtbares Gemisch beschrieben, das ein säurevernetzbares Melaminderivat, einen Novolak und chlorierte Benzophenone als photolytische Säurebildner enthält. Auch diese Gemische haben im tiefen UV-Bereich keine ausreichende Empfindlichkeit. Darüber hinaus sind Halogenwasserstoffsäuren als Vernetzungskatalysatoren unerwünscht, da diese bei den nachfolgenden Dotierungsprozessen mit den Dotierungsmitteln Reaktionen eingehen können. Des weiteren wirken im gehärteten Resist verbleibende Halogenwasserstoffsäuren stark korrosiv und können zur Zerstörung des zu bebildernden Materials und der Produktionsgeräte führen.

Das gleiche trifft für die in der EP 0 232 972 erwähnten säurebildenden Derivate des DDT's zu, die hochtoxisch sind und schon von daher nicht praxisgerecht sein können. Immerhin zeigen solche Verbindungen eine beachtliche Empfindlichkeit im tiefen UV-Bereich (200 bis 300 nm).

Als Verbindungen, die bei Bestrahlung eine starke Säure bilden, wurden bisher insbesondere Onium-Salze, wie Diazonium-, Phosphonium-, Sulfonium- und Jodonium-Salze von nicht nucleophilen Säuren, wie $HSbF_6$, $HAsF_6$, oder $HPF_6$ [J.V. Crivello, Polym. Eng. Sci., 23 (1983) 953] verwendet. Daneben sind Halogenverbindungen, insbesondere Trichlormethyltriazin-Derivate, Trichlormethyloxadiazol-Derivate, o-Chinondiazidsulfonylchloride und o-Chinondiazid-4-sulfonsäureester empfohlen worden.

Diese Verbindungen werden in negativ oder positiv arbeitenden strahlungsempfindlichen Gemischen verwendet. Die Verwendung solcher photolytischer Säurebildner bringt aber Nachteile mit sich, die ihre Einsatzmöglichkeiten in verschiedenen Anwendungsbereichen drastisch einschränken. So sind z.B. viele der Oniumsalze toxisch. Ihre Löslichkeit ist in vielen Lösemitteln unzureichend, weshalb nur wenige Lösemittel zur Herstellung einer Beschichtungslösung geeignet sind. Darüber hinaus werden bei Verwendung der Oniumsalze z.T. unerwünschte Fremdatome eingeführt, die insbesondere in der Mikrolithographie zu Prozeßstörungen führen können. Ferner bilden die Oniumsalze bei der Photolyse sehr stark korrodierend wirkende Brönstedt-Säuren. Diese Säuren greifen empfindliche Substrate an, so daß der Einsatz solcher Gemische zu unbefriedigenden Ergebnissen führt. Wie bereits früher erwähnt, bilden auch die Halogenverbindungen sowie die Chinondiazidsulfonsäurechloride stark korrosiv wirkende Halogenwasserstoffsäuren. Ferner besitzen solche Verbindungen auf bestimmten Substraten nur eine begrenzte Haltbarkeit, die dadurch verbessert wurde, daß zwischen Substrat und strahlungsempfindlicher, Verbindungen des Typs (a) enthaltender Schicht eine Zwischenschicht eingefügt wurde, was allerdings zu einer unerwünschten Zunahme von Defekten und zu einer verminderten Reproduzierbarkeit führte (DE-A 36 21 376 = US-A 4 840 867).

In neueren Arbeiten von F.M. Houlihan et al., SPIE 920, 67 (1988) wurden anhand positiv arbeitender Systeme gezeigt, daß neben den oben genannten Säurebildnern auch Nitrobenzyltosylate, die bei Belichtung Sulfonsäuren mit geringer Wanderungstendenz bilden, in bestimmten säurelabilen Resistformulierungen verwendbar sind. Es kann aus diesen Ergebnissen abgeleitet werden, daß solche Verbindungen auch für photohärtbare Systeme verwendet werden können. Die dabei erzielten Empfindlichkeiten, insbesondere gegenüber UV-Strahlung von 350 bis 450 nm, und die thermische Stabilität der Photoresists erwiesen sich jedoch als unzureichend.

In der nicht vorveröffentlichten deutschen Patentanmeldung P 40 06 190.6 wurden $\alpha,\alpha$-Bissulfonyl- oder $\alpha$-Carbonyl-$\alpha$-sulfonyldiazomethane als Säurebildner vorgeschlagen. Diese Verbindungen repräsentieren einen hohen Stand der gegenwärtigen Technik, zeigen aber häufig eine nicht voll befriedigende Thermostabilität.

Trotz der bisher geleisteten intensiven Forschungstätigkeit auf diesem Gebiet ist derzeit kein strahlungsempfindliches Gemisch bekannt, mit dem sich ein negativ arbeitendes strahlungsempfindliches Aufzeichnungsmaterial herstellen läßt, das eine hohe Empfindlichkeit sowohl im deep-UV- [DUV (200 bis 300 nm)] als auch im mid-UV- [MUV (300 bis 350 nm)] und near-UV-Bereich [NUV (350 bis 450 nm)] sowie eine hohe Auflösung besitzt, bereits bei kurzzeitiger Bestrahlung eine ausreichende Menge einer nicht korrodierend wirkenden Säure freisetzt, die stark genug ist, um Verbindungen des Typs b) zu spalten und das zudem noch wäßrig-alkalisch entwickelbar ist.

Aufgabe der Erfindung war es daher, ein strahlungsempfindliches Gemisch auf Basis von säurebildenden in Kombination mit säurevernetzbaren Verbindungen vorzuschlagen, wobei die photolytisch eine Säure bildende Verbindung a) möglichst stabil auf allen bekannten Substraten sein sollte und als Photoprodukt eine nicht korrosiv wirkende Säure liefert.

Die Aufgabe wird gelöst durch ein strahlungsempfindliches Gemisch mit

a) einer Verbindung, die unter Einwirkung von aktinischer Strahlung eine starke Säure bildet,

b) einer Verbindung mit mindestens zwei durch Säure vernetzbaren Gruppen und

c) einem in Wasser unlöslichen, in wäßrig-alkalischen Lösungen löslichen oder zumindest quellbaren polymeren Bindemittel,

das dadurch gekennzeichnet ist, daß die Verbindung a) ein 1-Sulfonyloxy-2-pyridon der allgemeinen Formel I

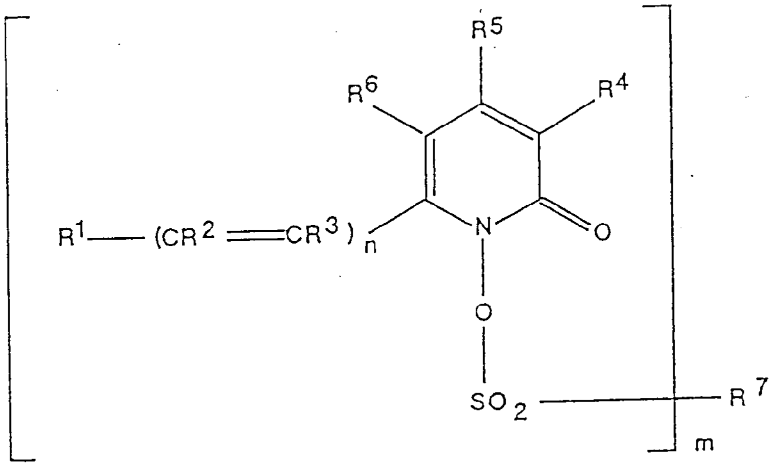

(I)

ist, worin

| | |
|---|---|
| $R^1$ | ein Wasserstoffatom, einen Alkyl-, Cycloalkyl-, Aryl-, Ferrocenyl-, Aralkenyl-, Heteroaryl- oder Heteroaralkenylrest, |
| $R^2$ | Wasserstoff, Chlor, Brom, einen Alkyl-, Cycloalkyl-, Aryl- oder Heteroarylrest oder |
| $R^1$ und $R^2$ | gemeinsam einen fünf- bis achtgliedrigen Ring ausbilden, |
| $R^3$ | Wasserstoff oder einen Alkylrest, |
| $R^4$ | Wasserstoff, Halogen, Nitro, Acylamino, Cyan, Thiocyanato, einen Alkyl-, Alkenyl-, Alkinyl-, Aryl-, Aralkyl-, Alkylthio-, Arylthio- oder Cycloalkylthiorest, |
| $R^5$ | Wasserstoff, einen Alkyl- oder Arylrest oder |
| $R^4$ und $R^5$ | zusammen einen fünf- bis achtgliedrigen Ring ausbilden, |
| $R^6$ | Wasserstoff, Halogen, Nitro, Acylamino, Cyan, Thiocyanato, einen Alkyl-, Alkenyl-, Alkoxyalkyl-, Aryl-, Aralkyl-, Alkylthio-, Cycloalkylthio- oder Arylthiorest, |
| $R^7$ | einen Alkyl-, Cycloalkyl, per- oder hochfluorierten Alkylrest oder einen Aryl-, Arylalkyl- oder Heteroarylrest oder einen Alkylen- oder Arylenrest |
| m | die Zahl 1 oder 2 und |
| n | eine ganze Zahl von 0 bis 3 |

bedeuten.

Die Verbindungen a) bilden unter Einwirkung von aktinischer Strahlung reaktive Zwischenstufen, die zur Einleitung spezieller chemischer Reaktionen, beispielsweise radikalischer Polymerisationen, befähigt sind. Sie bilden bei ihrer Bestrahlung jedoch insbesondere organische Säuren, die Reaktionen, wie kationische Polymerisationen, Vernetzungen oder Spaltungen säurelabiler Verbindungen katalysieren oder mit Basen reagieren können, was sich z.B. in einem Farbumschlag bei Indikatorfarbstoffen äußern kann.

Von den Verbindungen der allgemeinen Formel I sind solche bevorzugt, in denen

$R^1$ ein Alkyl- oder Cycloalkylrest oder ein Arylrest der allgemeinen Formel II

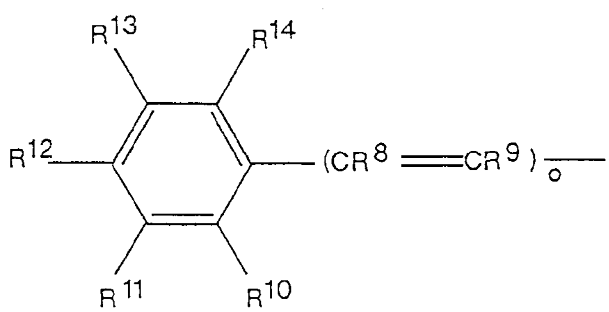

(II)

ist, worin

| | |
|---|---|
| $R^8$ und $R^9$ | gleich oder verschieden sind und Wasserstoff, eine niedere Alkyl- oder Arylgruppe darstellen, |
| $R^{10}$ bis $R^{14}$ | gleich oder verschieden sind und Wasserstoff, einen Alkyl-, Alkenyl-, Alkoxy-, |

Alkylthio-, Alkansulfonylrest mit jeweils bis zu 6 Kohlenstoffatomen, einen Cycloalkyloxy-, Cycloalkylthio-, Cycloalkansulfonylrest mit bis zu 8 Kohlenstoffatomen, gegebenenfalls am aromatischen Ring substituierten Phenyl-, Styryl-, Phenoxy-, Phenylthio-, Benzolsulfonyl-, Phenylalkoxy-, Phenylalkylthio-, Phenylalkansulfonylrest mit bis zu 3 Kohlenstoffatomen in der Alkylkette, Hydroxy, Halogen, Trifluormethyl, Nitro, Cyan, Alkoxycarbonyl, Carbamoyl, das gegebenenfalls am Stickstoff durch einen oder zwei Alkylrest(e), die gegebenenfalls zu einem 5- bis 7-gliedrigen Ring verbunden sind, substituiert ist, Sulfamoyl, das gegebenenfalls am Stickstoff durch ein oder zwei Alkylrest(e), die gegebenenfalls zu einem 5- bis 7-gliedrigen Ring verbunden sind, substituiert ist, Alkansulfonyloxy, Arylsulfonyloxy, Acylamino, Alkylamino oder Arylamino bedeuten, oder zwei der Substituenten $R^{10}$ bis $R^{14}$, die einander benachbart sind, einen oder zwei weitere ankondensierte Ring(e) bilden, und

o für die Zahl 0 oder 1 steht.

Daneben sind auch solche Verbindungen der allgemeinen Formel I bevorzugt, in denen $R^1$ ein 5- oder 6-gliedriger Heterocyclus mit bis zu drei Heteroatomen der allgemeinen Formel III

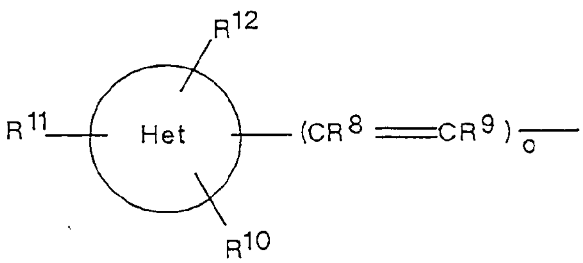

(III)

ist. Bevorzugte Verbindungen der allgemeinen Formel I sind schließlich auch solche, in denen

| | |
|---|---|
| $R^1$ | ein Ferrocenylrest und |
| $R^2$ | Wasserstoff, Chlor, Brom, Alkyl-, Cycloalkyl oder ein Rest der allgemeinen Formeln II oder III ist oder |
| $R^1$ und $R^2$ | gemeinsam einen fünf- bis achtgliedrigen Ring ausbilden, |
| $R^3$ | Wasserstoff oder ein Alkylrest, |
| $R^4$ | Wasserstoff, Halogen, Nitro, Acylamino, Cyan, Thiocyanato, ein Alkyl-, Aryl-, Alkylthio-, Arylthio- oder Cycloalkylthiorest, |
| $R^5$ | Wasserstoff, ein Alkyl- oder Arylrest ist oder |
| $R^4$ und $R^5$ | gemeinsam einen fünf- bis achtgliedrigen Ring ausbilden, |
| $R^6$ | Wasserstoff, Halogen, Nitro, Acylamino, Cyan, Thiocyanato, ein Alkyl-, Aryl-, Alkylthio-, Arylthio- oder Cycloalkylthiorest, |
| $R^7$ | ein Alkyl-, Cycloalkyl-, per- oder hochfluorierten Alkylrest oder ein Aryl-, Arylalkyl-, Aryl- oder Heteroarylrest oder ein Alkylen- oder Arylenrest ist und |
| m | für die Zahl 1 oder 2 und |
| n | für eine ganze Zahl von 0 bis 3 steht. |

Besonders bevorzugt sind solche Verbindungen der allgemeinen Formel I, worin $R^7$ ein Alkylrest mit 1 bis 4 Kohlenstoffatomen, ein hoch- oder perfluorierter Alkylrest mit 1 bis 4 Kohlenstoffatomen oder ein Arylrest der allgemeinen Formel IV

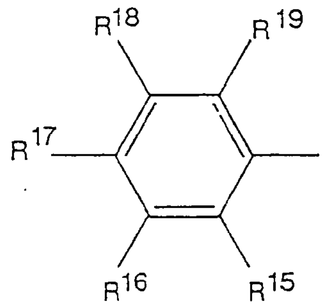

(IV)

ist, worin $R^{15}$ bis $R^{19}$ gleich oder verschieden sind und Wasserstoff- oder Halogenatome, die vorzugsweise Fluor, Chlor oder Brom sind, Alkylreste mit bis zu 6 Kohlenstoffatomen, die unsubstituiert oder durch Halogenatome, vorzugsweise Chlor oder Brom, Aryl- oder Aryloxyreste, substituiert sind und in denen einzelne Methylengruppen durch Sauerstoff- oder Schwefelatome ersetzt sein können und wobei jeweils zwei dieser Reste unter Ausbildung eines 5- oder 6-gliedrigen Rings verknüpft sein können, Cycloalkylreste mit bis zu 8 Kohlenstoffatomen, Alkenylreste mit bis zu 6 Kohlenstoffatomen, Aryl- oder Aryloxyreste mit bis zu 10 Kohlenstoffatomen bedeuten und die Gesamtzahl der Kohlenstoffatome der Reste $R^{15}$ bis $R^{19}$ maximal 12 beträgt.

Bevorzugt sind ebenfalls Verbindungen der allgemeinen Formel I, in denen $R^7$ ein Naphthyl- oder Heteroarylrest mit bis zu 10 Kohlenstoffatomen, ein Alkylenrest mit bis zu 6 Kohlenstoffatomen oder ein Arylen- oder Heteroarylenrest mit bis zu 14 Kohlenstoffatomen ist.

Ganz besonders bevorzugt sind solche Verbindungen der allgemeinen Formel I, worin

| | |
|---|---|
| $R^2$, $R^3$, $R^4$ und $R^6$ | ein Wasserstoffatom, |
| $R^5$ | eine Methylgruppe, |
| $R^7$ | einen Methyl-, Ethyl-, Trifluormethyl-, 1,1,2,3,3,3-Hexafluorpropyl-, Phenyl-, Tolyl-, 4-Fluorphenyl-, 4-Chlorphenyl-, 4-Bromphenyl oder 4-Nitrophenylrest, |
| m | die Zahl 1 und |
| n | die Zahl 0 oder 1 |

bedeuten.

Im einzelnen kann unter den besonders bevorzugten Verbindungen der Rest $R^7$ z.B. die folgende Bedeutung haben:

Methyl, Ethyl, Propyl, Isopropyl, Butyl, Hexyl, Octyl, Decyl, Dodecyl, Hexadecyl, Octadecyl, 10-Camphyl, Chlormethyl, 2-Chlorethyl, 3-Chlorpropyl, Dichlormethyl, Trichlormethyl, Difluormethyl, Trifluormethyl, 2,2,2-Trifluorethyl, 3,3,3,2,1,1-Hexafluorpropyl, Perfluorhexyl, Trimethylsilylmethyl, Methansulfonylmethyl, Phenyl, Benzyl, 4-Acetylphenyl, 4-Acetylaminophenyl, 2-, 3- oder 4-Bromphenyl, 2-, 3- oder 4-Chlorphenyl, 2-, 3- oder 4-Fluorphenyl, 4-Jodphenyl, 2-Cyanphenyl, 4-Cyanphenyl, 2-, 3- oder 4-Methylphenyl, 4-Ethylphenyl, 4-Propylphenyl, 4-Isopropylphenyl, 4-Isobutylphenyl, 4-tert.-Butylphenyl, 4-tert.-Amylphenyl, 4-Hexylphenyl, 4-Methoxyphenyl, 4-Butoxyphenyl, 4-Hexadecyloxyphenyl, 2-, 3- oder 4-Trifluormethylphenyl, 2- oder 4-Trifluormethoxyphenyl, 2-, 3- oder 4-Nitrophenyl, 3- oder 4-Carboxyphenyl, 2-Methoxycarbonylphenyl, 4-Tetrafluorethoxyphenyl, β-Styryl, 4-Acetylamino-3-chlorphenyl, 4-Acetylamino-3-fluorphenyl, 3,5-Bistrifluormethylphenyl, 2,5-Bis-(2,2,2-trifluorethoxy)phenyl, 2,5-Dimethylphenyl, 2,4-, 2,5- oder 3,4-Dimethoxyphenyl, 2,4-Diisopropylphenyl, 5-Brom-2-methoxyphenyl, 2- oder 3-Chlor-4-fluorphenyl, 3-Chlor-2-methylphenyl, 3-Chlor-4-methoxyphenyl, 2-Chlor-6-methylphenyl, 2-Chlor-4-trifluormethylphenyl, 5-Chlor-2-methoxyphenyl, 5-Fluor-2-methylphenyl, 2,5- oder 3,4-Dibromphenyl, 2,3-, 2,4- oder 2,5-, 2,6-, 3,4- oder 3,5-Dichlorphenyl, 2-(2,4-Dichlorphenoxy)phenyl, 4-(2-Chlor-6-nitrophenoxy)phenyl, 4-(3-Chlor-2-cyanphenoxy)phenyl, 2,4- oder 2,5-Difluorphenyl, 3-Carboxy-4-chlorphenyl, 4-Chlor-3-nitrophenyl, 2-Methyl-5-nitrophenyl, 4-Chlor-3- oder 2-Chlor-5-trifluormethylphenyl, 4-(2,2-Dichlorcyclopropyl)phenyl, 2,4-Dinitrophenyl, 4-Dimethylamino-3-nitrophenyl, 2-Nitro-4-trifluormethylphenyl, 2,4,6-Trimethylphenyl, 2,4,6-Triisopropylphenyl, 2,3,4-, 2,4,5- oder 2,4,6-Trichlorphenyl, 4-Chlor-2,5-dimethylphenyl, 2,4-Dichlor-5-methylphenyl, 3,5-Dichlor-2-hydroxyphenyl, 3,5-Dichlor-4-(4-nitrophenoxy)phenyl, 4-(2-Chlor-4-nitrophenoxy)-3,5-Dichlorphenyl, 4-Brom-2,5-difluorphenyl, 2,4-Dimethyl-3-nitrophenyl, 3,5-Dinitro-4-methylphenyl, 2,3,5,6-Tetramethylphenyl, 4-Methoxy-2,3,6-trimethylphenyl, 2,5-Dibrom-3,6-difluorphenyl, 2,3,4,5,6-Pentafluorphenyl, 1- oder 2-Naphthyl, 5-Diazo-6-oxo-5,6-dihydro-1-naphthyl, 6-Diazo-5-oxo-5,6-dihydro-1-naphthyl, 5-Diazo-6-oxo-5,6-dihydro-8-naphthyl, 5-Diazo-3-methoxy-6-oxo-5,6-dihydro-8-naphthyl, 5-Dimethylamino-1-naphthyl, 1-Anthracenyl, 2-Anthrachinonyl, 8-Chinolinyl, 2-Thienyl, 5-Chlor-2-thienyl, 4-Brom-2,5-dichlor-3-thienyl, 4,5-Dibrom-2-thienyl, 2,3-Dichlor-5-thienyl, 2-Brom-3-Chlor-5-thienyl, 3-Brom-2-chlor-5-thienyl, 3-Brom-5-chlor-2-thienyl, 2,5-Dichlor-3-thienyl, 2-(2-Pyridyl)-5-thienyl, 5-Chlor-1,3-dimethyl-4-pyrazolyl, 3,5-Dimethyl-4-isoxazolyl, 2,4-Dimethyl-5-thiazolyl, 2-Acetylamino-4-methyl-5-thiazolyl oder

1,4-Butylen, 2-Oxo-1,3-propylen, 1,2- oder 1,3-Phenylen, 3-Methyl-1,2-phenylen, 2,4,6-Trimethyl-1,3-phenylen, 4,4′-Biphenylen, 4,4′-Methylendiphenylen, 4,4′-Oxybiphenylen, 1,5-Naphthylen, 2-Chlor-3,5-thienylen, 2-(1-Methyl-5-trifluormethylpyrazol-3-yl)-3,5-thienylen.

Im einzelnen kann unter den besonders bevorzugten Verbindungen der Rest $R^1$ z.B. die folgende Bedeutung haben:

Methyl, Chlormethyl, Brommethyl, Ethyl, Propyl, Isopropyl, Butyl, Isobutyl, Hexyl, Cyclohexyl, Octyl, Phenyl, 4-Acetylaminophenyl, 4-Acetoxyphenyl, 3- oder 4-Benzyloxyphenyl, 3-Benzyloxy-4-methoxyphenyl, 4-Benzyloxy-3-methoxyphenyl, 4-Biphenyl, 3,5-Bis(trifluormethyl)phenyl, 2-, 3- oder 4-Fluorphenyl, 2-, 3- oder 4-Chlorphenyl, 2-,3- oder 4-Bromphenyl, 4-Jodphenyl, 2-, 3- oder 4-Cyanphenyl, 2-, 3- oder 4-Methylphenyl, 2-, 3- oder 4-Ethylphenyl, 2-, 3- oder 4-Propylphenyl, 2-, 3- oder 4-Isopropylphenyl, 2-, 3- oder 4-Butylphenyl, 2-, 3- oder 4-Isobutylphenyl, 2-, 3- oder 4-sec.-Butylphenyl, 2-, 3- oder 4-tert.-Butylphenyl, 2-, 3- oder 4-Pentylphenyl, 2-, 3- oder 4-Hexylphenyl, 2-, 3- oder 4-Cyclohexylphenyl, 2-, 3- oder 4-Nonylphenyl oder 2-, 3- oder 4-Dodecylphenyl, 2-, 3- oder 4-Methoxyphenyl, 2-, 3- oder 4-Ethoxyphenyl, 2-, 3- oder 4-Isopropoxyphenyl, 2-, 3- oder 4-Butoxyphenyl, 2-, 3- oder 4-Pentoxyphenyl, 2-, 3- oder 4-Octyloxyphenyl, oder 2-, 3- oder 4-Decyloxyphenyl, 2,3-, 2,4-, 2,6-, 3,4- oder 3,5- Difluorphenyl, 2,3-, 2,4-, 2,6-, 3,4- oder 3,5-Dichlorphenyl, 2,3-, 2,4-, 2,6-, 3,4- oder 3,5-Dibromphenyl, 3-(3,4-Dichlorphenoxy)phenyl, 3-(3,5-Dichlorphenoxy)phenyl, 3-Brom-4-fluorphenyl, 5-Brom-2,4-dimethoxyphenyl, 2-Chlor-6-fluorphenyl, 2-Chlor-5-, 2-Chlor-6-, 4-Chlor-3- oder 5-Chlor-2-nitrophenyl, 3-(4-Chlorphenoxy)phenyl, 3,4-Bisbenzyloxy-phenyl, 2,3-, 2,4-, 2,5-, 3,4- oder 3,5-Dimethoxy-phenyl, 2,3-, 2,4-, 2,5-, 3,4- oder 3,5-Diethoxy-phenyl, 2,3-, 2,4-, 2,5-, 3,4- oder 3,5-Dibutoxy-phenyl oder 2,3-, 2,4-, 2,5-, 3,4- oder 3,5-Dihexyloxy-phenyl, 2,4-Dimethoxy-3-methyl-phenyl, 2-Ethoxy-5-methoxy-phenyl, 3-Chlor-4-methyl-phenyl, 2,4- oder 2,5-Dimethyl-phenyl, 2-, 3- oder 4-Methoxyethyl-phenyl, 2-, 3- oder 4-Ethoxyethyl-phenyl, 2-, 3- oder 4-Butoxyethyl-phenyl, 2,6-Dinitrophenyl, 2,4,6-Trimethylphenyl, 3,4,5-Trimethoxy-phenyl, 3,4,5-Triethoxy-phenyl, 2,3- oder 3,4-Methylendioxyphenyl, 2- oder 3-Thienyl, 2-Fluorenyl, 9-Anthryl, 1-Pyrenyl, 9-Phenanthryl, 5-Brom-2-thienyl, 3-Methyl-2-thienyl, 5-Methyl-2-thienyl, 5-Nitrofuryl, 10-Chlor-9-anthryl oder Ferrocenyl.

Diese Reste sind besonders deshalb bevorzugt, weil die ihnen zugrundeliegenden Ausgangsverbindungen kommerziell erhältlich sind. Weitere Verbindungen sind aber auf einfache Weise nach dem Fachmann geläufigen Methoden herstellbar.

Die oben aufgeführten Verbindungen haben Absorptionsmaxima im Bereich zwischen 200 bis 550 nm und sind daher für eine Bestrahlung mit energiereicher UV-Strahlung im Bereich der UV2- (220 bis 280 nm), UV3- (300 bis 350 nm) oder UV4- (350 bis 450 nm) Strahlung sowie mit energiereichem sichtbaren Licht (450 bis 550 nm) sehr gut geeignet. Sie zeigen auch bei Bestrahlung mit Strahlung einer Wellenlänge $<$ 220 nm hohe Aktivitäten; sind aber wegen ihrer hohen Absorption in diesem Bereich bevorzugt für sogenannte "Toplayer Imaging" Verfahren anwendbar.

1-Benzolsulfonyloxy- und 1-(Toluol-4-sulfonyloxy)-2-pyridon sowie Verfahren zu deren Herstellung sind bekannt (E.C. Taylor et al., J. Org. Chem., 35, 1672, 1970). Die Strahlungsempfindlichkeit dieser Verbindungen wurde jedoch nicht erkannt. Neue 1-Sulfonyloxy-2-pyridone sind in der gleichzeitig eingereichten deutschen Patentanmeldung P 41 12 967.9 beschrieben.

Die Verwendung von 1-Sulfonyloxy-2-pyridonen als Photooxidantien in strahlungsempfindlichen Gemischen, die einen Leukofarbstoff enthalten, ist aus der US-A 4 425 424 bekannt. In derartigen Gemischen bewirkt das Photooxidans bei der Bestrahlung beispielsweise eine Oxidation des Leukofarbstoffs, der dabei eine intensive Farbänderung eingeht und einen visuellen Kontrast zwischen belichteten und unbelichteten Bereichen hervorruft. Solche Farbumschläge sind in der Technik beispielsweise bei der Herstellung von Druckformen erwünscht, um nach der Belichtung bereits vor der Entwicklung das Kopierergebnis beurteilen zu können.

Das erfindungsgemäße strahlungsempfindliche Gemisch zeichnet sich durch eine hohe Empfindlichkeit über einen weiten Spektralbereich aus. Es zeigt eine hohe thermische Stabilität und schafft die Möglichkeit, auch feinste Strukturen einer Vorlage detailgenau wiederzugeben. Die bei der Bestrahlung gebildete Säure wirkt nicht korrodierend, so daß das Gemisch auch auf empfindlichen Substratmaterialien Verwendung finden kann.

Überraschenderweise bilden sich bei der Bestrahlung der erfindungsgemäßen Gemische Sulfonsäuren mit einer hohen Quantenausbeute. Infolge ihres hohen Molekukargewichts zeigen die Sulfonsäuren eine viel geringere Diffusionsneigung bzw. Beweglichkeit in der strahlungsempfindlichen Schicht. Diese hohe Effizienz der Säurebildung bedeutet, daß die erfindungsgemäßen Gemische eine wesentlich gesteigerte Empfindlichkeit aufweisen. Die erfindungsgemäßen, negativ arbeitenden, strahlungsempfindlichen Gemische zeigen zudem nicht nur eine hohe thermische und Plasmaätzbeständigkeit sondern auch hervorragende lithographische Eigenschaften, die eine Auflösung im Halbmikrometer- und teilweise auch im Sub-Halbmikrometer-Bereich erlauben. Man erhält nach dem bildmäßigen Bestrahlen und anschließendem Entwickeln ein detailgetreues Abbild der Maske. Die Resistfelder weisen steile Flanken auf. In den nicht bestrahlten Bereichen wird die Resistschicht vollständig abgelöst, d. h. es bleiben keinerlei Reste oder Rückstände der Schicht auf dem Substrat. Die bei der Photolyse gebildeten Sulfonsäuren führen zu einer effizienten Vernetzung der Resist-Komponente b), was die Herstellung von hochempfindlichen, negativ arbeitenden Gemischen erlaubt.

Weiterhin war es überraschend, daß die 1-Sulfonyloxy-2-pyridone der allgemeinen Formel I auch durch energiereiche, kurzwellige Strahlung aktivierbar sind und damit beispielsweise die Herstellung eines hochempfindlichen Photoresists für energiereiche UV2-Strahlung (248 nm) möglich ist. Insbesondere war es aber unerwartet, daß sogar noch im Bereich der klassischen optischen Lithographie (436 nm) eine ausreichende spektrale Empfindlichkeit vorhanden ist, die zu einer Spaltung des Moleküls in eine Sulfonsäure führt.

In dem erfindungsgemäßen Gemisch sollen die 1-Sulfonyloxy-2-pyridone eine höhere molare Absorption für Strahlung der Wellenlänge von etwa 220 bis 500 nm aufweisen als die übrigen Bestandteile des Gemisches.

Mit den erfindungsgemäßen Gemischen hergestellte Aufzeichnungsmaterialien zeigen eine höchsten Ansprüchen genügende Bilddifferenzierung und eine Verbesserung des Kontrasts und des Auflösungsvermögens. Die erfindungsgemäßen Gemische erlauben beispielsweise die Herstellung eines hochempfindlichen negativ arbeitenden Photoresists für energiereiche UV2-Strahlung (z. B. 248 nm).

Da das erfindungsgemäße Gemisch über einen weiten Spektralbereich empfindlich ist, ist zum bildmäßigen Bestrahlen aktinische Strahlung allgemein geeignet. Als aktinische Strahlung soll in diesem Zusammenhang jede Strahlung verstanden werden, deren Energie mindestens der des kurzwelligen sichtbaren Lichts (< 550 nm) entspricht. Geeignet ist dabei insbesondere UV-Strahlung im Bereich von 150 bis 550 nm, bevorzugt von 200 bis 450 nm, besonders bevorzugt von 240 bis 440 nm, aber auch Elektronen- oder Röntgenstrahlung.

Darüber hinaus lassen sich die mehrfunktionellen Sulfonsäureester auch mit Onium-Salzen, Halogenverbindungen, insbesondere Trichlormethyltriazinderivaten oder Trichlormethyloxadiazolderivaten, 1,2-Disulfonen, o-Chinondiazidsulfonylchloriden oder Organometall-Organohalogen-Kombinationen kombinieren. Es kommen aber auch Mischungen mit Bis(sulfonyl)diazomethanen und Sulfonyl-carbonyldiazomethanen in Frage. In solchen Gemischen können jedoch die eingangs erwähnten Nachteile wieder auftreten.

Der Anteil an säurebildenden Verbindungen a) im erfindungsgemäßen Gemisch liegt im allgemeinen bei 0,5 bis 25 Gew.-%, bevorzugt bei 1 bis 15 Gew.-%, bezogen auf das Gesamtgewicht der Feststoffe im Gemisch.

Als säurevernetzbare Verbindungen b) kommen besonders die in der GB 2 082 339 offenbarten Resole, daneben auch mit Alkoxymethyl- oder Oxiranylmethyl-Gruppen substituierte Aromaten (EP-A 0 212 482) sowie monomere und oligomere Melamin- bzw. Harnstoff-Formaldehyd-Kondensate (EP-A 0 133 216, DE-A 36 34 371, DE 37 11 264) in Betracht. Beispiele für den ersten Typ sind insbesondere die kommerziell erhältlichen Resolprodukte Bakelite R 5363, Bakelite R 17620, Bakelite R 10282 und Kelrez 40-152 (Bakelite und Kelrez sind eingetragene Warenzeichen). Resolderivate sind jedoch insgesamt nicht bevorzugt, da sie im tiefen UV-Bereich verhältnismäßig hohe Absorptionen aufweisen und damit zu einer Beeinträchtigung der Bildwiedergabe führen.

Besser geeignet sind die aus der EP-A 0 212 482 bekannten Vernetzer der allgemeinen Formel V

$$(R^{4'}O\text{-}CHR^{6'})_n\text{-}A\text{-}(CHR^{6'}\text{-}OR^{5'})_m \qquad \mathbf{(V)}$$

in der

| | |
|---|---|
| A | -B- oder -B-Y-B- ist und |
| B | einen ggf. substituierten einkernigen aromatischen Kohlenwasserstoff oder eine Sauerstoff oder Schwefel enthaltende heterocyclische aromatische Verbindung darstellt, |
| Y | eine Einfachbindung, $(C_1\text{-}C_4)$Alkylen oder $(C_1\text{-}C_4)$Alkylendioxy, deren Ketten durch Sauerstoffatome unterbrochen sein können, -O-, -S-, $-SO_2-$, -CO-, $-CO_2-$, $-O-CO_2-$, -CONH- oder $-O-C_6H_4-O-$ bedeutet, |
| $R^{4'}$ und $R^{5'}$ | Wasserstoff, $(C_1\text{-}C_6)$Alkyl, $C_5$ oder $C_6$-Cycloalkyl-, ggf. substituiertes $(C_6\text{-}C_{12})$Aryl, $(C_6\text{-}C_{12})$ Aralkyl oder Acyl ist, |
| $R^{6'}$ | Wasserstoff, $(C_1\text{-}C_4)$Alkyl oder ggf. substituiertes Phenyl, |
| m | eine ganze Zahl von 0 bis 3 und |
| n | eine ganze Zahl von 1 bis 3, wobei n+m mindestens 2 ist, bedeuten. |

Typische Vernetzer sind demnach Aromaten und Heterocyclen, die mehrfach mit Hydroxymethyl-, Acetoxymethyl- und Methoxymethyl-Gruppen substituiert sind. Polymere oder oligomere Verbindungen, die derartige Substitutionsmuster aufweisen und beispielsweise aus der EP-A 0 282 724 bekannt sind, lassen sich ebenfalls vorteilhaft verwenden.

Weitere bevorzugte Vernetzer sind Melamin/Formaldehyd-Derivate, die beispielsweise mindestens zwei freie N-Hydroxymethyl-, N-Alkoxymethyl- oder N-Acyloxymethylgruppen aufweisen. Insbesondere die N-Alkoxymethylderivate sind zum Einsatz in dem erfindungsgemäßen strahlungsempfindlichen Gemisch geeignet.

Schließlich können auch niedermolekulare oder oligomere Silanole als siliciumhaltige Vernetzer Verwendung finden. Beispiele hierfür sind etwa Dimethyl- oder Diphenylsilandiole, oder bereits vorkondensierte Oligomere mit diesen Einheiten. Für den erfindungsgemäßen Zweck verwendbare Verbindungen sind beispielsweise in der EP-A 0 377 155 offengelegt.

Die Vernetzer sind in Lage, bei erhöhten Temperaturen unter dem Einfluß der photolytisch erzeugten Säure mit den polymeren Bindemitteln zu vernetzen. Allgemein sind sie dadurch gekennzeichnet, daß sie unter den genannten Temperatur- und Säurebedingungen ein Carbonium-ion bilden können.

Der Anteil der säurevernetzbaren Verbindung b) am erfindungsgemäßen strahlungsempfindlichen Gemisch liegt zweckmäßig bei 1 bis 50 Gew.-%, vorzugsweise bei 5 bis 25 Gew.-%, jeweils bezogen auf das Gesamtgewicht der festen Bestandteile des Gemisches.

Das erfindungsgemäße strahlungsempfindliche Gemisch enthält ferner mindestens ein polymeres, in Wasser unlösliches, in wäßrig-alkalischen Lösungen dagegen lösliches, zumindest quellbares Bindemittel c).

Das Bindemittel zeichnet sich im besonderen dadurch aus, daß es mit den übrigen Bestandteilen des erfindungsgemäßen strahlungsempfindlichen Gemisches gut verträglich ist und insbesondere im Wellenlängenbereich von 190 bis 550 nm eine möglichst geringe Eigenabsorption, d.h. eine hohe Transparenz, aufweist.

Für die klassischen Anwendungen, d. h. mit Lichtquellen im nahen UV-Bereich, sind dazu insbesondere Bindemittel auf der Basis von Novolak-Kondensationsharzen, die in der Regel in Kombination mit Naphthochinondiaziden als photoaktive Komponenten eingesetzt worden sind, geeignet. Solche Phenol-Formaldehyd-Kondensate sind mehrfach beschrieben worden und können als phenolische Komponente Phenol, die drei stellungsisomeren Kresole oder andere Alkylphenole, z. B. Xylenole, als Komponenten enthalten. Neben Formaldehyd können auch andere Aldehyde zur Herstellung des Polymeren herangezogen werden. Allerdings lassen sich auch die nachstehend beschriebenen, Hydroxylgruppen enthaltenden Polymeren für Bestrahlungen mit nahem UV-Licht verwenden, wobei diese den oben bezeichneten Novolak-Polymeren in einem Anteil von bis zu 50%, bevorzugt bis zu 20%, zugemischt sein können.

Für Anwendungen im UV2 Bereich sind jedoch andere polymere Materialien erforderlich. Hierunter fallen insbesondere nicht diejenigen Novolake, die in der Regel in Kombination mit Naphthochinondiaziden als photoaktive Komponenten eingesetzt werden. Zwar lassen Novolake nach bildmäßiger Belichtung mit kurzwelliger Strahlung in den belichteten Bereichen eine Erhöhung der Löslichkeit gegenüber wäßrig-alkalischen Entwicklern erkennen, doch ist ihre Eigenabsorption in dem für die Belichtung gewünschten Wellenlängenbereich unerwünscht hoch.

Novolak-Kondensationsharze können aber in Mischung mit anderen als Bindemittel geeigneten Harzen mit höherer Transparenz eingesetzt werden. Die Mischungsverhältnisse richten sich dabei vorwiegend nach der Art des mit dem Novolakharz zu mischenden Bindemittels. Insbesondere spielen dessen Grad an Eigenabsorption im genannten Wellenlängenbereich, aber auch die Mischbarkeit mit den anderen Bestandteilen des strahlungsempfindlichen Gemisches eine entscheidende Rolle. Im allgemeinen kann aber das Bindemittel des erfindungsgemäßen strahlungsempfindlichen Gemisches bis zu 50 Gew.-%, insbesondere bis zu 20 Gew.-%, eines Novolak-Kondensationsharzes enthalten. Als Bindemittel geeignet sind Homo- oder Copolymere des 4-Hydroxystyrols sowie seiner Alkylderivate, z.B. des 3-Methyl-4-hydroxystyrols, des 2,3- oder 3,5-Dimethyl-4-hydroxystyrols sowie Homo- oder Copolymere anderer Vinylphenole, z. B. des 2- oder 3-Hydroxystyrols oder der Ester oder Amide von Acrylsäure mit phenolischen Gruppen aufweisenden Aromaten. Als Comonomere können polymerisierbare Verbindungen wie Styrol, Methyl(meth)acrylat oder ähnliche eingesetzt werden.

Gemische mit erhöhter Plasmabeständigkeit werden erhalten, wenn zur Herstellung der Bindemittel Silicium enthaltende Vinylmonomere, z. B. Vinyltrimethylsilan, mitverwendet werden. Die Transparenz dieser Bindemittel ist im Deep-UV-Bereich im allgemeinen höher, so daß eine verbesserte Strukturierung möglich ist.

Mit gleichem Erfolg lassen sich auch Homo- oder Copolymere des Maleinimids verwenden. Auch diese Bindemittel zeigen hohe Transparenz im Deep-UV-Bereich. Als Comonomere werden auch hier bevorzugt Styrol, substituierte Styrole, Vinylether, Vinylester, Vinylsilylverbindungen oder (Meth)acrylsäureester eingesetzt.

Schließlich sind darüber hinaus auch Copolymere des Styrols mit Comonomeren verwendbar, die in wäßrig alkalischen Lösungen eine Löslichkeitserhöhung bewirken. Hierzu zählen beispielsweise Maleinsäureanhydrid und Maleinsäurehalbester.

Die genannten Bindemittel können auch untereinander gemischt werden, sofern sich dadurch die optische Qualität des strahlungsempfindlichen Gemisches nicht verschlechtert. Bindemittelgemische sind jedoch nicht bevorzugt.

Die Menge des Bindemittels beträgt im allgemeinen 30 bis 95 Gew.-%, bevorzugt 40 bis 90 Gew.-%, besonders bevorzugt 50 bis 85 Gew.-% bezogen auf das Gesamtgewicht der festen Anteile des strahlungsempfindlichen Gemisches.

Die Extinktion des Bindemittels bzw. der Kombination von Bindemitteln für Strahlung der Wellenlänge von etwa 220 bis 500 nm sollte weniger als 0,5, bevorzugt weniger als 0,3 $\mu m^{-1}$, betragen.

Ferner können den erfindungsgemäßen strahlungsempfindlichen Gemischen gegebenenfalls Farbstoffe, Pigmente, Weichmacher, Netzmittel und Verlaufmittel, aber auch Polyglykole, Celluloseether, z. B. Ethylcellulose, zur Erfüllung spezieller Erfordernisse, wie Flexibilität, Haftung und Glanz, zugesetzt werden.

Soll ein Substrat beschichtet werden, so wird das erfindungsgemäße strahlungsempfindliche Gemisch zweckmäßig in einem Lösemittel oder in einer Kombination von Lösemitteln gelöst. Hierfür besonders geeignet sind Ethylenglykol und Propylenglykol sowie die davon abgeleiteten Mono- und Dialkylether, besonders die Mono- und Dimethylether sowie die Mono- und Diethylether, Ester abgeleitet aus aliphatischen ($C_1$-$C_6$)Carbonsäuren und entweder ($C_1$-$C_8$)Alkanolen oder ($C_1$-$C_8$)Alkandiolen oder ($C_1$-$C_6$)Alkoxy-($C_1$-$C_8$)alkanolen, beispielsweise Ethylacetat, Hydroxyethylacetat, Alkoxyethylacetat, n-Butylacetat, Propylenglykolmonoalkyletheracetat, insbesondere Propylenglykolmethyletheracetat und Amylacetat, Ether, wie Tetrahydrofuran und Dioxan, Ketone, wie Methylethylketon, Methylisobutylketon, Cyclopentanon und Cyclohexanon, N,N-Dialkyl-carbonsäureamide, wie N,N-Dimethylformamid und N,N-Dimethylacetamid, aber auch Hexamethylphosphorsäuretriamid, N-Methyl-pyrrolidin-2-on und Butyrolacton, sowie beliebige Mischungen davon. Besonders bevorzugt von diesen sind die Glykolether, aliphatischen Ester und Ketone.

Letztendlich hängt die Wahl des Lösemittels bzw. Lösemittelgemisches ab von dem angewandten Beschichtungsverfahren, der gewünschten Schichtstärke und den Trocknungsbedingungen. Ebenso müssen die Lösemittel unter den angewendeten Bedingungen gegenüber den übrigen Schichtbestandteilen chemisch inert sein.

Die mit den genannten Lösemitteln hergestellte Lösung hat in der Regel einen Feststoffgehalt von 5 bis 60 Gew.-%, vorzugsweise bis 50 Gew.-%.

Gegenstand der Erfindung ist schließlich auch ein strahlungsempfindliches Aufzeichnungsmaterial, das im wesentlichen aus einem Substrat und einer darauf befindlichen strahlungsempfindlichen Schicht aus dem erfindungsgemäßen strahlungsempfindlichen Gemisch besteht.

Als Substrate kommen alle Materialien in Frage, aus denen Kondensatoren, Halbleiter, mehrlagige gedruckte Schaltungen oder integrierte Schaltkreise bestehen bzw. hergestellt werden können. Speziell sind Siliciumsubstrate zu nennen, die auch thermisch oxidiert und/oder mit Aluminium beschichtet, aber auch dotiert sein können. Daneben sind alle anderen in der Halbleitertechnologie üblichen Substrate möglich, wie Siliciumnitrid, Galliumarsenid und Indiumphosphid. Weiterhin kommen die aus der Flüssigkristalldisplay-Herstellung bekannten Substrate in Frage, wie Glas oder Indium-Zinnoxid, ferner Metallplatten und -folien - beispielsweise aus Aluminium, Kupfer, Zink -, Bimetall- und Trimetallfolien, aber auch elektrisch nichtleitende Folien, die mit Metallen bedampft sind, und Papier. Diese Substrate können thermisch vorbehandelt, oberflächlich aufgerauht, angeätzt oder, zur Verbesserung erwünschter Eigenschaften, z. B. zur Erhöhung der Hydrophilie, mit Chemikalien vorbehandelt sein.

Um der strahlungsempfindlichen Schicht einen besseren Zusammenhalt und/oder eine bessere Haftung auf der Substratoberfläche zu verleihen, kann in ihr ein Haftvermittler enthalten sein. Der gleiche Effekt läßt sich mit einer haftvermittelnden Zwischenschicht erreichen. Bei Silicium- bzw. Siliciumdioxid-Substraten kommen hierfür Haftvermittler vom Aminosilan-Typ, wie z. B. 3-Aminopropyltriethoxysilan oder Hexamethyldisilazan, in Frage.

Geeignete Träger für die Herstellung von photomechanischen Aufzeichnungsschichten, wie Druckformen für den Hochdruck, Flachdruck, Siebdruck und Flexodruck sind besonders Aluminiumplatten, die gegebenenfalls vorher anodisch oxidiert, gekörnt und/oder silikatisiert werden, daneben Zink- und Stahlplatten, die gegebenenfalls verchromt werden, sowie Kunststoffolien und Papier.

Das erfindungsgemäße Aufzeichnungsmaterial wird mit aktinischer Strahlung bildmäßig belichtet. Als Strahlungsquellen eignen sich besonders Metallhalogenidlampen, Kohlebogenlampen, Xenonlampen und Quecksilberdampflampen. Ebenso kann eine Belichtung mit energiereicher Strahlung wie Laser-, Elektronen- oder Röntgenstrahlung erfolgen. Besonders bevorzugt sind jedoch Lampen, die Licht einer Wellenlänge von 190 bis 260 nm ausstrahlen können, d.h. insbesondere Xenon- und Quecksilberdampflampen. Darüber hinaus lassen sich auch Laserlichtquellen verwenden, z. B. Excimerlaser, insbesondere KrF- oder ArF-Laser, die bei 248 bzw. 193 nm emittieren. Die Strahlungsquellen müssen in den genannten Wellenlängenbereichen eine ausreichende Emission aufweisen.

Die Stärke der lichtempfindlichen Schicht hängt vom Verwendungszweck ab. Sie beträgt im allgemeinen zwischen 0,1 und 100 µm, bevorzugt zwischen 1 und 10 µm.

Gegenstand der Erfindung ist ferner ein Verfahren zur Herstellung eines strahlungsempfindlichen Aufzeichnungsmaterials. Das Auftragen des strahlungsempfindlichen Gemisches auf das Substrat kann durch Aufsprühen, Fließbeschichten, Walzen, Schleuder- und Tauchbeschichten erfolgen. Danach wird das Lösemittel durch Verdampfen entfernt, so daß auf der Oberfläche des Substrats die strahlungsempfindliche Schicht zurückbleibt. Die Entfernung des Lösemittels kann durch Erhitzen der Schicht auf Temperaturen bis zu 150 °C gefördert werden. Das Gemisch kann aber auch zunächst auf obengenannte Weise auf einen Zwischenträger aufgetragen werden, von dem aus es unter Druck und erhöhter Temperatur auf das endgültige Trägermaterial übertragen wird. Als Zwischenträger können grundsätzlich alle auch als Trägermaterialien geeigneten Materialien Anwendung finden. Anschließend wird die Schicht bildmäßig bestrahlt und zur Beschleunigung der Vernetzungsreaktion kurz erwärmt. Danach behandelt man die Schicht mit einer Entwicklerlösung, die die nicht bestrahlten Bereiche der Schicht löst und entfernt, so daß ein Abbild der bei der bildmäßigen Bestrahlung verwendeten Vorlage auf der Substratoberfläche verbleibt.

Als Entwickler eignen sich besonders wäßrige Lösungen, die Silikate, Metasilikate, Hydroxide, Hydrogen- und Dihydrogenphosphate, Carbonate oder Hydrogencarbonate von Alkalimetall-, Erdalkalimetall- und/oder Ammoniumionen enthalten, aber auch Ammoniak und dergleichen. Metallionenfreie Entwickler werden in der US-A 4 729 941, der EP-A 0 062 733, der US-A 4 628 023, der US-A 4 141 733, der EP-A 0 097 282 und der EP-A 0 023 758 beschrieben. Der Gehalt dieser Substanzen in der Entwicklerlösung beträgt im allgemeinen 0,1 bis 15 Gew.-%, vorzugweise 0,5 bis 5 Gew.-%, bezogen auf das Gewicht der Entwicklerlösung. Metallionenfreie Entwickler werden bevorzugt verwendet. Den Entwicklern können geringe Mengen eines Netzmittels zugesetzt sein, um die Ablösung der löslichen Bereiche der Schicht zu erleichtern.

Die entwickelten Schichtstrukturen können nachgehärtet werden. Dies geschieht im allgemeinen durch Erhitzen auf einer hot plate bis zu einer Temperatur unterhalb der Fließtemperatur und anschließendes ganzflächiges Belichten mit dem UV-Licht einer Xenon-Quecksilber-Dampflampe (Bereich von 200 bis 250 nm). Durch die Nachhärtung werden die Bildstrukturen zusätzlich vernetzt, so daß sie im allgemeinen eine Fließbeständigkeit bis zu Temperaturen von über 200 °C aufweisen. Die Nachhärtung kann auch ohne Temperaturerhöhung allein durch Bestrahlen mit energiereichem UV-Licht in hoher Dosis erfolgen.

Verwendung findet das erfindungsgemäße strahlungsempfindliche Gemisch bei der Herstellung von integrierten Schaltungen oder von einzelnen elektrischen Bausteinen mit lithographischen Prozessen, da sie eine hohe Lichtempfindlichkeit aufweisen, besonders bei Bestrahlung mit Licht einer Wellenlänge zwischen 190 bis 300 nm. Da die Gemische bei Belichtung sehr gut ausbleichen, lassen sich feinere Strukturen erzielen als dies mit den bekannten Gemischen möglich ist. Die entwickelte Resistschicht dient dabei als Maske für die folgenden Prozeßschritte. Solche Schritte sind z. B. das Ätzen des Schichtträgers, das Implantieren von Ionen in den Schichtträger oder das Abscheiden von Metallen oder anderen Materialien auf dem Schichtträger.

Die nachstehend beschriebenen Beispiele illustrieren die Erfindung, sollen aber nicht beschränkend wirken. Im Folgenden steht Gt für Gewichtsteile und Vt für Volumenteile, die sich zu Gewichtsteilen wie g zu $cm^3$ verhalten.

Herstellungsbeispiel 1

Stufe 1: Zu 280 Gt Aluminiumtrichlorid in 250 Vt Methylenchlorid wurden bei 15°C 88 Gt Acetylchlorid und 128 Gt 2,3-Dimethyl-crotonsäure-methylester zugetropft. Die Lösung wurde 3 Stunden zum Rückfluß erhitzt und nach Abkühlen auf Eis gegeben. Nach Abtrennung der organischen Phase wurde die verbliebene Mischung mit 500 Vt Methylenchlorid ausgerührt. Die vereinigten organischen Phasen wurden mit Wasser gewaschen und anschließend langsam mit einer Lösung aus 76 Gt Hydroxylamin-hydrochlorid in 200 Vt Wasser versetzt. Bei der einsetzenden Erwärmung destillierte das Methylenchlorid ab. Die Lösung wurde 3 Stunden auf 120°C Badtemperatur erwärmt. Nach dem Abkühlen wurde sie dann mit n-Hexan extrahiert. Die verbliebene wäßrige Lösung wurde mit 5%iger Natriumhydroxidlösung auf pH 5 eingestellt, der ausfallende Niederschlag abgesaugt, mit Wasser verrieben, erneut abgesaugt und getrocknet. Es wurden 82 Gt 1-Hydroxy-3,4,6-trimethyl-2-pyridon mit einem Schmelzpunkt von 130°C erhalten.
Stufe 2: Zu einer auf 5°C gekühlten Lösung aus 5,0 Gt der vorstehend beschriebenen Verbindung und 6,8 Gt 4-Fluorbenzolsulfonylchlorid in 60 Vt Methylenchlorid wurde unter Rühren eine Lösung aus 3,4 Gt Triethylamin in 20 Vt Methylenchlorid so langsam zugetropft, daß die vorgegebene Temperatur konstant blieb. Die Lösung wurde auf Raumtemperatur erwärmt und 72 Stunden gerührt. Dann wurde die organische Phase mit Wasser gewaschen, getrocknet und eingeengt. Es wurden 10,8 Gt eines Rohprodukts mit einem Schmelzpunkt von 120°C erhalten. Dieses wurde erneut in Methylenchlorid gelöst und auf eine Kieselgelsäule gegeben; als Laufmittel wurde Methylenchlorid verwendet. Die vereinigten Produktfraktionen wurden eingeengt. Man erhielt 8,6 Gt 1-(4-Fluorbenzolsulfonyloxy)-3,4,6-trimethyl-2-pyridon mit einem Schmelzpunkt von 123°C.

| | | | | |
|---|---|---|---|---|
| Analyse: | ber. | C 54,01% | H 4,53% | N 4,50% |
| (311,34) | gef. | C 53,9% | H 4,7% | N 4,6%. |

Herstellungsbeispiel 2

1. Stufe: Zu einer Suspension von 532 Gt Aluminiumtrichlorid in 250 Vt Ethylenchlorid und 282 Gt Chloracetylchlorid wurden bei 50 bis 60°C 230 Gt 3-Methylcrotonsäure-methylester so zugegeben, daß die Temperatur gerade gehalten wurde. Anschließend wurde eine Stunde auf 65 bis 70°C erhitzt und auf Eis gegossen. Die wäßrige Phase wurde mit Methylenchlorid extrahiert und die organische Phase mit Wasser und gesättigter Natriumhydrogencarbonatlösung gewaschen. Nach Trocknung über Natriumsulfat wurde fraktioniert destilliert. Ausbeute: 280 Gt (74%), Sdp. 120 bis 122°C/5 Torr.
2. Stufe: 382 Gt des vorstehend beschriebenen Produkts wurden in einer Mischung aus 1000 Vt Eisessig und 10 Vt konzentrierter Schwefelsäure gelöst und zum Sieden erhitzt. Über eine kurze Kolonne wurde die berechnete Menge Methylacetat abdestilliert. Anschließend wurde der Eisessig im Vakuum entfernt und der Rückstand in Eiswasser gegeben, wobei das Pyron kristallisierte. Zur weiteren Reinigung kann

das abgetrennte Produkt bei 116 bis 117°C/2 Torr destilliert werden. Nach Umkristallisation aus Tetrachlorkohlenstoff erhielt man 296 Gt 6-Chlormethyl-4-methyl-2-pyron. Ausbeute: 93%, Fp. 78°C.
3. Stufe: 320 Gt des vorstehend beschriebenen Produkts wurden zusammen mit 540 Gt Triphenylphosphin und 1500 Vt Acetonitril 8 Stunden zum Rückfluß erhitzt. Die Mischung wurde in Eis gekühlt und das ausgefallene Produkt abgesaugt. Die Mutterlauge wurde eingeengt, wobei weiteres Produkt ausfiel, das abgesaugt wurde. Es wurden 799 Gt (4-Methyl-6-oxo-6H-pyron-2-ylmethyl)-triphenyl-phosphoniumchlorid erhalten.
4. Stufe: 106 Gt des vorstehend beschriebenen Produkts wurden zusammen mit 35,5 Gt 4-Chlorbenzaldehyd in 200 Vt Methanol gelöst. Dazu wurde eine Lösung aus 6 Gt Natrium in 150 Vt Methanol gegossen, wobei sich die Mischung vorübergehend rot färbte und stark exotherm reagierte. Es wurde 6 Stunden bei Raumtemperatur gerührt, auf -25°C gekühlt und das ausgefallene Produkt abgesaugt. Dieses wurde mit gekühltem Methanol gewaschen, mit Wasser verrührt und erneut abgesaugt. Es wurden 26 Gt 6-(4-Chlorstyryl)-4-methyl-2-pyron erhalten, das aus Acetontril umkristallisiert werden kann. Fp. 144°C.
5. Stufe: 22,5 Gt des vorstehend beschriebenen Produkts wurden mit 9 Gt Hydroxylaminhydrochlorid und 110 Gt 2-Aminopyridin auf etwa 70°C erwärmt. Die Mischung wurde 72 Stunden bei dieser Temperatur belassen, wobei nach 3, 18, 30 und 42 Stunden jeweils 3,3 Gt Hydroxylaminhydrochlorid nachdosiert wurden. Die erkaltete Mischung wurde in Methylenchlorid aufgenommen und mit verdünnter Salzsäure und Wasser gewaschen. Die organische Phase wurde in einer Lösung aus 10 Gt Natriumhydroxid in 700 Vt entionisiertem Wasser aufgerührt, das entstandene Natriumsalz abfiltriert und in 600 Vt heißem Wasser gelöst. Durch Zugabe von Eisessig wurde die wäßrige Lösung auf pH 5 eingestellt und abgekühlt. Das dabei kristallisierende Rohprodukt wurde abgenutscht und getrocknet. Es wurden 15 Gt eines Rohprodukts mit einem Schmelzpunkt von 195°C erhalten, das aus Methylenchlorid umkristallisiert wurde. Es wurden gelbliche Kristalle [6-(4-Chlor-styryl)-1-hydroxy-4-methyl-2-pyridon] mit einem Schmelzpunkt von 205°C erhalten.

| | | | | |
|---|---|---|---|---|
| Analyse: | ber. | C 64,25% | H 4,62% | N 5,35% |
| (261,70) | gef. | C 64,2% | H 4,6% | N 5,4% |

6. Stufe: Zu einer Lösung aus 4 Gt des vorstehend beschriebenen Produkts und 20 Gt Methansulfonylchlorid in 50 Vt Methylenchlorid wurden 1,85 Gt Triethylamin bei 10°C in 20 Vt Methylenchlorid zugetropft. Die Lösung wurde 24 Stunden bei Raumtemperatur nachgerührt, mit Wasser ausgeschüttelt und das Lösemittel abrotiert. Das kristalline Produkt wurde getrocknet, auf eine Silicagelsäule gegeben und mit Methylenchlorid eluiert. Die vereinigten Produktfraktionen ergaben nach Einengen 4,2 Gt 6-(4-Chlor-styryl)-1-methansulfonyloxy-4-methyl-2-pyridon mit einem Zersetzungspunkt von 190°C. Eine Probe wurde aus Acetonitril umkristallisiert und ergab ein Produkt mit einem Schmelzpunkt von 193°C .

| | | | | |
|---|---|---|---|---|
| Analyse: | ber. | C 53,02% | H 4,15% | N 4,12% |
| (339,77) | gef. | C 52,7% | H 4,4% | N 4,2% |

Herstellungsbeispiel 3

Stufe 1: 11,2 Gt 4,6-Diphenyl-2-pyron wurden zusammen mit 30 Gt 2-Aminopyridin und 10,4 Gt Hydroxylamin-hydrochlorid 22 Stunden bei 80°C gerührt. Nach dem Erkalten wurden 200 Vt Methylenchlorid zugesetzt. Anschließend wurde die organische Phase mit einer Lösung aus 30 Vt konzentrierter Salzsäure und 200 Vt Wasser und dann mit Wasser allein gewaschen, zweimal mit einer Lösung aus 10 Gt Natriumhydroxid und 300 Gt Wasser ausgeschüttelt und die wäßrigen Extrakte durch Zugabe von Eisessig auf pH 4 eingestellt. Der Niederschlag wurde abgesaugt, mit Wasser gewaschen und getrocknet. Die Ausbeute betrug 10,6 Gt 1-Hydroxy-4,6-diphenyl-2-pyridon mit einem Schmelzpunkt von 159°C.
Stufe 2: Eine auf 5°C gekühlte Lösung aus 5,0 Gt der vorstehend beschriebenen Verbindung und 4,64 Gt 4-Chlorbenzolsulfonylchlorid in 50 Vt Methylenchlorid wurde unter Rühren mit einer Lösung aus 2,1 Gt Triethylamin in 20 Vt Methylenchlorid so langsam versetzt, daß die Temperatur konstant blieb. Die Lösung wurde auf Raumtemperatur erwärmt und 120 Stunden gerührt. Dann wurde die organische Phase mit Wasser gewaschen, getrocknet und eingeengt. Es wurden 8,6 Gt eines Rohprodukts erhalten. Dieses wurde zweimal in heißem Diisopropylether digeriert und abgesaugt. Anschließend wurde aus Acetonitril umkristallisiert. Es wurden 7,1 Gt 1-(4-Chlor-benzolsulfonyloxy)-4,6-diphenyl-2-pyridon erhalten. Die Verbindung wies einen Zersetzungspunkt von 165°C auf.

| | | | | |
|---|---|---|---|---|
| Analyse: | ber. | C 63,08% | H 3,68% | N 3,20% |
| (437,91) | gef. | C 63,3% | H 3,7% | N 3,3%. |

Herstellungsbeispiel 4

Stufe 1: 41,4 Gt 6-Cyclohexyl-1-hydroxy-4-methyl-2-pyridon wurden in 220 Gt konzentrierter Schwefelsäure gelöst und innerhalb 1 Stunde unter Eiskühlung mit 18 Gt Natriumnitrat versetzt. Die Lösung wurde 7 Stunden bei 0°C nachgerührt, auf Eis gegeben und mit Methylenchlorid extrahiert. Die organische Phase wurde mehrfach mit Wasser gewaschen, getrocknet, filtriert und eingeengt. Der Rückstand wurde aus Methanol umgelöst, ausgefällt und anschließend aus Tetrachlorkohlenstoff umkristallisiert. Es wurden 11,6 Gt des in 3-Stellung nitrierten Produkts mit einem Schmelzpunkt von 160°C erhalten.
Stufe 2: Eine auf 5°C gekühlte Lösung aus 6,0 Gt der vorstehend beschriebenen Verbindung und 3,0 Gt Methansulfonylchlorid in 50 Vt Methylenchlorid wurde unter Rühren mit einer Lösung aus 2,6 Gt Triethylamin in 20 Vt Methylenchlorid so langsam versetzt, daß die Temperatur konstant blieb. Die Lösung wurde auf Raumtemperatur erwärmt und 100 Stunden gerührt. Dann wurde die organische Phase mit Wasser gewaschen, getrocknet und eingeengt. Es wurden 8,3 Gt eines Rohprodukts mit einem Schmelzpunkt von etwa 170°C erhalten. Dieses wurde in Methylenchlorid gelöst und mit Methylenchlorid als Laufmittel über eine Kieselgelsäule chromatographiert. Die erhaltenen Fraktionen wurden eingeengt, wobei 7,2 Gt 6-Cyclohexyl-1-methansulfonyloxy-4-methyl-3-nitro-2-pyridon erhalten wurden. Die Verbindung schmolz bei 169°C.

| | | | | |
|---|---|---|---|---|
| Analyse: | ber. | C 47,26% | H 5,49% | N 8,48% |
| (330,37) | gef. | C 47,1% | H 5,5% | N 8,5%. |

Herstellungsbeispiel 5

Stufe 1: 50 Gt 1-Hydroxy-4,6-dimethyl-2-pyridon wurden zusammen mit 131 Gt Benzolsulfinsäurenatriumsalz, 24 Gt Paraformaldehyd und 250 Gt Eisessig 8 Stunden bei 130°C gerührt. Nach Abkühlen wurde das ausgefallene Produkt abgesaugt, mit Wasser und Methanol gewaschen und getrocknet.
Stufe 2: 6,0 Gt Natrium wurden in 90 Gt Methanol gelöst und mit 27 Gt der vorstehend beschriebenen Verbindung versetzt. Die Lösung wurde etwa 120 Stunden bei 80°C gerührt. Die erkaltete Mischung wurde vom Lösemittel befreit in Wasser gelöst und mit konzentrierter Salzsäure auf pH 3 eingestellt. Die Ausfällung wurde abfiltriert und die verbliebene Mutterlauge mit Methylenchlorid extrahiert. Die organische Phase wurde gewaschen, getrocknet und eingeengt. Der Rückstand wurde aus Methanol umkristallisiert und ergab 10,2 Gt des gewünschten Produkts mit einem Schmelzpunkt von 120°C.
Stufe 3: Eine auf 5°C gekühlte Lösung aus 6,0 Gt der vorstehend beschriebenen Verbindung und 3,4 Gt Methansulfonylchlorid in 50 Vt Methylenchlorid wurde unter Rühren mit einer Mischung aus 3,0 Gt Triethylamin in 20 Vt Methylenchlorid so langsam versetzt, daß die vorgegebene Temperatur konstant blieb. Die Mischung wurde auf Raumtemperatur erwärmt und 80 Stunden gerührt. Dann wurde die organische Phase mit Wasser gewaschen, getrocknet und eingeengt. Es wurden 10,2 Gt eines viskosen Rohprodukts erhalten. Dieses wurde in Methylenchlorid gelöst und mit Methylenchlorid als Laufmittel über eine Kieselgelsäule chromatographiert. Die erhaltenen Fraktionen wurden eingeengt, wobei 5,9 Gt rohes 1-Methansulfonyloxy-3,5-bis-methoxymethyl-4,6-dimethyl-2-pyridon erhalten wurden. Nach dem Umkristallisieren aus Diisopropylether verbleiben 4,8 Gt Reinprodukt, das bei 73°C schmolz.

| | | | | |
|---|---|---|---|---|
| Analyse: | ber. | C 47,20% | H 6,27% | N 4,59% |
| (305,36) | gef. | C 46,9% | H 6,6% | N 4,6%. |

Herstellungsbeispiel 6

Stufe 1: Zu 28 Gt O-Benzylhydroxylamin und 23,7 Gt Triethylamin in 200 Vt Methylenchlorid wurde innerhalb von 20 Minuten bei einer Temperatur von 20°C eine Mischung aus 23,6 Gt Cyanessigsäurechlorid in 25 Gt Methylenchlorid getropft. Nachdem die Lösung eine Stunde lang nachgerührt worden war, wurde sie mit Wasser gewaschen, getrocknet und eingeengt. Es wurden 45 Gt N-Benzyloxy-2-cyan-acetamid erhalten.
Stufe 2: 24 Gt des vorstehend beschriebenen Produkts, 12,7 Gt Acetylaceton und 1 Gt Diethylamin wurden in 50 Vt Ethanol gelöst und 1,5 Stunden zum Rückfluß erhitzt. Die Lösung wurde auf -20°C gekühlt und die ausgefallenen Kristalle, die das gewünschte 1-Benzyloxy-3-cyan-4,6-dimethyl-2-pyridon darstellen, abgesaugt.
Stufe 3: 28 Gt des vorstehend beschriebenen Produkts wurden in einem Autoklaven in 400 Vt Methanol gelöst und mit 1 Gt eines 10% Palladium/Bariumsulfat-Katalysators versetzt. Die Mischung wurde bei Raumtemperatur mit Wasserstoff hydriert, wobei 2,8 l Wasserstoff aufgenommen wurden. Nicht gelöste Bestandteile der Mischung wurden abfiltriert und die Lösung eingeengt. Man erhielt 16,5 Gt 3-Cyan-1-hydroxy-4,6-dimethyl-2-pyridon mit einem Schmelzpunkt von 240°C.
Stufe 4: Eine auf 5°C gekühlte Lösung aus 2,9 Gt der vorstehend beschriebenen Verbindung und 2,3 Gt Methansulfonylchlorid in 50 Vt Methylenchlorid wurde unter Rühren mit einer Lösung aus 2,0 Gt Triethylamin in 20 Vt Methylenchlorid so langsam versetzt, daß die vorgegebene Temperatur konstant blieb. Nach dem Erwärmen auf Raumtemperatur wurde die Lösung noch 100 Stunden weiter gerührt, mit Wasser gewaschen, getrocknet und eingeengt. Es wurden 4,0 Gt eines Rohprodukts mit einem Schmelzpunkt von etwa 150°C erhalten. Dieses wurde in Methylenchlorid gelöst und mit Methylenchlorid als Laufmittel über eine Kieselgelsäule chromatographiert. Die erhaltenen Fraktionen wurden eingeengt, wobei 3,2 Gt rohes 3-Cyan-1-methansulfonyloxy-4,6-dimethyl-2-pyridon erhalten wurden. Nach Umkristallisieren aus n-Hexan und Trocknen wurden 3,0 Gt Reinprodukt erhalten, das bei 151°C schmolz, sich wieder verfestigte und einen zweiten scharfen Schmelzpunkt bei 167°C aufwies.

| | | | | |
|---|---|---|---|---|
| Analyse: | ber. | C 44,62% | H 4,16% | N 11,57% |
| (242,27) | gef. | C 44,3% | H 4,2% | N 11,4%. |

Herstellungsbeispiel 7

Stufe 1: Zu 380 Gt Aluminiumtrichlorid in 350 Vt Methylenchlorid wurde innerhalb von zwei Stunden bei etwa 10°C ein Gemisch aus 106 Gt Isobuttersäurechlorid und 137 Gt 3-Methyl-crotonsäure-methylester zugetropft. Die Mischung wurde 15 Stunden zum Rückfluß erhitzt und nach Abkühlen auf Eis zersetzt. Nach Zusatz von weiterem Methylenchlorid wurde die Mischung ausgerührt, die organische Phase abgetrennt, gewaschen und getrocknet. Nach Einengen des Lösemittels wurde der Rückstand im Vakuum destilliert. Ausbeute: 164 Gt 6-Isopropyl-4-methyl-2-pyron, Kp. 95 bis 110°C/1 Torr.
Stufe 2: 16 Gt Hydroxylamin-hydrochlorid wurden in einer Mischung aus 10 Gt Wasser/100 Gt Methanol gelöst und mit 36,8 Gt des vorstehend beschriebenen Produkts versetzt. Nach zweistündigem Rühren bei Raumtemperatur wurden zur Lösung 20 Gt Natriumhydroxid in 30 Gt Wasser gegeben, 1 Stunde nachgerührt, mit 200 Gt Wasser versetzt und mit Methylenchlorid extrahiert. Anschließend wurde die wäßrige Phase auf pH 4 eingestellt und das ausgefallene Produkt (1-Hydroxy-6-isopropyl-4-methyl-2-pyridon) abgenutscht und getrocknet.
Stufe 3: Eine auf 5°C gekühlte Lösung aus 4,0 Gt der vorstehend beschriebenen Verbindung und 3,45 Gt Methansulfonylchlorid in 50 Vt Methylenchlorid wurde unter Rühren mit einer Lösung aus 2,8 Gt Triethylamin in 30 Vt Methylenchlorid so langsam versetzt, daß die vorgegebene Temperatur konstant blieb. Die Mischung wurde auf Raumtemperatur erwärmt und 35 Stunden gerührt. Dann wurde die organische Phase mit Wasser gewaschen, getrocknet und eingeengt. Es wurden 6,2 Gt eines Rohprodukts mit einem Schmelzpunkt von etwa 110°C erhalten. Dieses wurde in Methylenchlorid gelöst und mit Methylenchlorid als Laufmittel über eine Kieselgelsäule chromatographiert. Die erhaltenen Fraktionen wurden eingeengt, wobei 4,9 Gt 6-Isopropyl-1-methansulfonyloxy-4-methyl-2-pyridon erhalten wurden. Nach Umkristallisation aus Diisopropylether wurden 3,9 Gt Produkt erhalten, das bei 113°C schmolz.

| | | | | |
|---|---|---|---|---|
| Analyse: | ber. | C 48,96% | H 6,16% | N 5,71% |
| (245,31) | gef. | C 49,2% | H 6,3% | N 5,6%. |

Herstellungsbeispiel 8

1. Stufe: Zu 79,3 Gt 6-Chlormethyl-4-methyl-2-pyron (s. Herstellungsbeispiel 2, 2. Stufe) wurden unter Rühren in einer Destillationsapparatur bei 100°C langsam 108 Gt Triethylphosphit zugetropft. Dabei destillierte Ethylchlorid in die Vorlage über. Nachdem die Ethylchlorid-Abspaltung schwächer wurde, wurde die Badtemperatur langsam auf 130°C erhöht und etwa 6 Stunden bei dieser Temperatur nachgerührt. Nach Ablauf wurden weitere 320 Gt 6-Chlormethyl-4-methyl-2-pyron zur Mischung hinzugefügt und langsam 432 Gt Triethylphosphit bei einer Badtemperatur von 140°C zugetropft. Es wurde erneut 9 Stunden bei dieser Temperatur nachgerührt. Nach dem Abkühlen wurden dann anschließend flüchtige Bestandteile der Mischung bei 70°C im Ölpumpenvakuum etwa 3 Stunden abdestilliert. Es verblieben 610 Gt 6-Diethoxyphosphorylmethyl-4-methyl-2-pyron als zäher Rückstand, der nach einiger Zeit zu kristallisieren begann.

2. Stufe: Zu einer Mischung aus 45,5 Gt Benzophenon, 65 Gt der vorstehend beschriebenen Verbindung und 200 Vt 1,2-Dimethoxyethan wurde unter Inertgas und intensivem Rühren 7,75 Gt Natriumhydrid (80% Suspension) zugegeben und die Mischung 24 Stunden bei 70°C gerührt. Das Gemisch wurde in Methylenchlorid aufgenommen, mehrmals mit Wasser gewaschen, getrocknet und am Rotationsverdampfer eingeengt. Man erhielt 74,3 Gt eines aus zwei Komponenten bestehenden Rohprodukts, das über eine Kieselgelsäule mit Methylenchlorid als Laufmittel aufgetrennt wurde. Die Fraktionen, die das Produkt mit der höheren Retentionszeit enthielten wurden vereint und eingeengt. Man erhielt 55 Gt kristallines 6-(2,2-Diphenyl-vinyl)-4-methyl-2-pyron, das aus Hexan umkristallisiert werden kann.

3. Stufe: 20 Gt des vorstehend beschriebenen Produkts wurden mit 5,6 Gt Hydroxylaminhydrochlorid und 80 Gt Aminopyridin auf etwa 75°C erwärmt. Die Mischung wurde 58 Stunden bei dieser Temperatur belassen, wobei nach 6, 22 und 32 Stunden jeweils 2,8 Gt Hydroxylaminhydrochlorid nachdosiert wurden. Die erkaltete Mischung wurde in Methylenchlorid aufgenommen und mit verdünnter Salzsäure und Wasser gewaschen, getrocknet und eingeengt. Der mit 22 Gt anfallende Rückstand wurde aus Acetonitril umkristallisiert. Es wurden 14 Gt eines gelben Produkts [6-(2,2-Diphenyl-vinyl)-1-hydroxy-4-methyl-2-pyridon] mit einem Schmelzpunkt von 169°C erhalten.

| | | | | |
|---|---|---|---|---|
| Analyse: | ber. | C 79,18% | H 5,65% | N 4,62% |
| (303,26) | gef. | C 79,0% | H 5,8% | N 4,5% |

4. Stufe: Zu einer Lösung aus 8 Gt des vorstehend beschriebenen Produkts und 3,5 Gt Methansulfonylchlorid in 70 Vt Methylenchlorid wurden bei 5 bis 10°C 3 Gt Triethylamin in 20 Vt Methylenchlorid zugetropft. Die Mischung wurde 24 Stunden bei Raumtemperatur nachgerührt, mit Wasser ausgeschüttelt und das Lösemittel abrotiert. Der etwa 12,5 Gt betragende viskose Rückstand kristallisierte beim Stehenlassen und wies einen Schmelzpunkt von etwa 130°C auf. Das Rohprodukt wurde über eine Silicagelsäule mit Methylenchlorid eluiert. Die vereinigten Produktfraktionen ergaben nach Einengen 8,2 Gt 6-(2,2-Diphenyl-vinyl)-1-methansulfonyloxy-4-methyl-2-pyridon mit einem Schmelzpunkt von 140°C.

| | | | | |
|---|---|---|---|---|
| Analyse: | ber. | C 66,12% | H 5,02% | N 3,67% |
| (381,44) | gef. | C 65,7% | H 5,1% | N 3,4% |

Herstellungsbeispiel 9

Stufe 1: 85 Gt (4-Methyl-6-oxo-6H-pyron-2-ylmethyl)-triphenyl-phosphoniumchlorid (s. Herstellungsbeispiel 2, 3. Stufe) und 41,2 Gt Anthracen-9-carbaldehyd wurden in 200 Vt Methanol dispergiert. Dazu wurde unter Rühren ziemlich rasch eine Lösung von 5 Gt Natrium in 100 Vt Methanol zugegeben, wobei sich die Mischung erwärmte. Es wurde 1 Stunde bei etwa 50°C, anschließend 72 Stunden bei Raumtemperatur weitergerührt, anschließend auf -25°C abgekühlt und das ausgefallene Produkt abgesaugt. Das Produkt

wurde mit Methanol gewaschen, dann mit Wasser verrührt und erneut abgesaugt. Es wurden 52 Gt 6-(2-Anthracen-9-yl-vinyl)-4-methyl-2-pyron mit einem Schmelzpunkt von etwa 200°C erhalten, das aus Acetonitril umkristallisiert einen Schmelzpunkt von 203°C aufwies.

Stufe 2: 20 Gt des vorstehend beschriebenen Pyrons wurden mit 5,6 Gt Hydroxylaminhydrochlorid und 80 Gt 2-Aminopyridin auf 70°C erwärmt. Die Mischung wurde 72 Stunden bei dieser Temperatur belassen, wobei nach 7, 23 und 32 Stunden jeweils 2,8 Gt Hydroxylaminhydrochlorid nachdosiert wurden. Die erkaltete Mischung wurde in Methylenchlorid aufgenommen und mit verdünnter Salzsäure und Wasser gewaschen. Dabei fiel ein Teil des Produkts aus. Die organische Phase wurde am Rotationsverdampfer eingeengt. Der Rückstand wurde aus Dimethylformamid (DMF) umkristallisiert. Die erhaltenen Kristalle wurden zusammen mit dem ausgefallenen Produkt erneut aus DMF umkristallisiert und mit Methanol gewaschen. Man erhielt 12,6 Gt eines analysenreinen orangefarbenen Pulvers [6-(2-Anthracen-9-yl-vinyl)-1-hydroxy-4-methyl-2-pyridon], das einen Schmelzpunkt > 260°C aufwies.

| | | | | |
|---|---|---|---|---|
| Analyse: | ber. | C 80,71% | H 5,24% | N 4,28% |
| (327,39) | gef. | C 80,9 % | H 5,4 % | N 4,3 % |

3. Stufe: 4,5 Gt der vorstehend beschriebenen Verbindung und 1,83 Gt Methansulfonylchlorid wurden in 50 Vt Methylenchlorid gelöst und auf 5°C gekühlt. Dazu wurde eine Mischung von 1,6 Gt Triethylamin in 20 Vt Methylenchlorid langsam zugetropft. Es wurde 3 Tage bei Raumtemperatur nachgerührt. Die organische Phase wurde mit Wasser gewaschen, getrocknet und das Lösemittel am Rotationsverdampfer abgezogen. Der Rückstand wurde erneut in Methylenchlorid aufgenommen und über eine Kieselgelsäule mit Methylenchlorid als Laufmittel eluiert. Die deutlich erkennbare Hauptfraktion wurde gesammelt, vom Lösemittel befreit und das verbliebene schaumartige Produkt mit warmen Diisopropylether verrührt. Nach Trocknung wurden 1,9 Gt 6-(2-Anthracen-9-yl-vinyl)-1-methansulfonyloxy-4-methyl-2-pyridon erhalten, das sich bei einer Temperatur von 180°C unter Verpuffung zersetzte.

| | | | | |
|---|---|---|---|---|
| Analyse: | ber. | C 68,13% | H 4,72% | N 3,46% |
| (405,48) | gef. | C 68,1 % | H 4,9 % | N 3,3 % |

Herstellungsbeispiel 10

Stufe 1: 26 Gt 6-Diethoxyphosphorylmethyl-4-methyl-2-pyron (s. Herstellungsbeispiel 8, 1. Stufe) und 17,4 Gt 4-Trifluormethylbenzaldehyd wurden in 80 Vt 1,2-Dimethoxyethan gelöst. Unter Stickstoff wurden dann portionsweise 3,2 Gt einer 80% Natriumhydrid-Dispersion derart zugefügt, daß sich die Reaktionsmischung nicht über 50°C erwärmte. Sie wurde 18 Stunden bei dieser Temperatur nachgerührt und nach dem Abkühlen mit Methylenchlorid verdünnt. Die Lösung wurde mehrmals mit Wasser gewaschen, getrocknet und eingeengt. Es verblieben 26,9 Gt eines kristallinen Pulvers, das über eine Kieselgelsäule mit Methylenchlorid als Laufmittel eluiert wurde. Aus der Hauptfraktion wurden nach Einengen 18,9 Gt eines Pulvers vom Schmelzpunkt 155°C erhalten, das sich als das gewünschte analysenreine 4-Methyl-6-(4-trifluormethyl-styryl)-2-pyron erwies.

Stufe 2: 15 Gt des vorstehend beschriebenen Produkts, 45 Gt Imidazol, 5 Gt N-Methylpyrrolidon und 5,6 Gt Hydroxylamin-hydrochlorid wurden unter Rühren 55 Stunden auf 75°C erwärmt. Nach 8, 24 und 32 Stunden Reaktionszeit wurden je 2,8 Gt Hydroxylamin-hydrochlorid nachdosiert. Die erkaltete Mischung wurde in Methylenchlorid aufgenommen, mit Wasser gewaschen, getrocknet und eingeengt. Es wurden 14,6 Gt eines Rohprodukts erhalten, das aus Ethylenglykolmonomethylether umkristallisiert wurde. Das auskristallisierte 1-Hydroxy-4-methyl-6-(4-trifluormethyl-styryl)-2-pyridon wies einen Schmelzpunkt von 230°C auf.

| | | | | | |
|---|---|---|---|---|---|
| Analyse: | ber. | C 61,02% | H 4,10% | F 19,30% | N 4,74% |
| (295,28) | gef. | C 61,3% | H 4,1% | | |

Stufe 3: 1,8 Gt der vorstehend beschriebenen Verbindung und 1,9 Gt 4-Brombenzolsulfonylchlorid wurden

in 40 Vt Methylenchlorid gelöst und auf 5°C gekühlt. Dazu wurde eine Mischung von 1,0 Gt Triethylamin in 5 Vt Methylenchlorid langsam zugetropft. Es wurde 66 Stunden bei Raumtemperatur nachgerührt. Die organische Phase wurde mit Wasser gewaschen, getrocknet und das Lösemittel am Rotationsverdampfer abgezogen. Der Rückstand (3,2 Gt) wurde erneut in Methylenchlorid aufgenommen und über eine Kieselgelsäule mit Methylenchlorid/Methanol (99/1) als Laufmittel eluiert. Die deutlich erkennbare Hauptfraktion wurde gesammelt, vom Lösemittel befreit und das verbliebene schaumartige Produkt mit warmen Diisopropylether verrührt, wobei Kristallisation des Produkts eintrat. Nach Trocknung wurden 2,2 Gt 1-(4-Brombenzolsulfonyloxy)-4-methyl-6-(4-trifluormethyl-styryl)-2-pyridon, das bei einer Temperatur von 158°C schmolz, erhalten.

| | | | | | |
|---|---|---|---|---|---|
| Analyse: | ber. | C 49,04% | H 2,94% | N 2,72% | F 11,08% |
| (514,33) | gef. | C 48,6 % | H 3,1 % | N 2,7 % | |

Weitere geeignete 1-Sulfonyloxy-2-pyridone sind in der gleichzeitig eingereichten deutschen Patentanmeldung P 41 12 966.0 aufgelistet.

Anwendungsbeispiele

Die Beispiele 1 bis 16 belegen die Eignung des erfindungsgemäßen Gemisches für Aufzeichnungsmaterialien in der Mikrolithographie unter Verwendung von Strahlung unterschiedlichster Energie. Anhand der Vergleichsbeispiele 17 und 18 wird die Überlegenheit der erfindungsgemäßen Gemische gegenüber dem Stand der Technik belegt. Die Beispiele 19 und 20 dokumentieren die Anwendbarkeit des Gemisches in gedruckten Schaltungen und Flachdruckplatten.

Beispiel 1

Es wurde eine Beschichtungslösung hergestellt aus
7,5 Gt eines Kresol-Formaldehyd-Novolaks mit einem Erweichungsbereich von 105 bis 120°C,
2,0 Gt eines Kresol-Formaldehyd-Resols (Bakelite R5363) und
0,5 Gt 6-(4-Chlor-styryl)-1-methansulfonyloxy-4-methyl-2-pyridon in
42 Gt Propylenglykol-monomethylether-acetat.

Die Lösung wurde durch ein Filter mit einem Porendurchmesser von 0,2 µm filtriert und auf einen mit einem Haftvermittler (Hexamethyldisilazan) behandelten Wafer bei 3.000 Umdrehungen aufgeschleudert. Nach 1 min Trocknen bei 100°C auf der hot plate betrug die Schichtdicke 1,05 µm.

Das Aufzeichnungsmaterial wurde bildmäßig unter einer Vorlage mit der UV-Strahlung (365 nm) einer Xenon-Quecksilberdampflampe mit einer Energie von 60 $mJ/cm^2$ belichtet. Danach wurde der Wafer 5 min bei Raumtemperatur gelagert und dann auf einer hot plate 2 min bei 100°C nachgetempert.

Entwickelt wurde das Aufzeichnungsmaterial mit einem 0,3 n alkalischen Entwickler folgender Zusammensetzung:
5,3 Gt Natriummetasilikat x 9 $H_2O$,
3,4 Gt Trinatriumphosphat x 12 $H_2O$,
0,3 Gt Natriumdihydrogenphosphat und
91 Gt vollentsalztes Wasser.

Nach einer Entwicklungsdauer von 60 s erhielt man ein fehlerfreies negatives Abbild der Maske mit steilen Resistflanken, wobei auch Strukturen < 0,6 µm detailgetreu aufgelöst wurden. Eine Untersuchung der Flanken der Resistprofile mit Rasterelektronenmikroskopie belegte, daß diese praktisch senkrecht zur Substratoberfläche ausgerichtet waren.

Beispiel 2

Es wurde eine Beschichtungslösung hergestellt aus
7,5 Gt eines Copolymeren aus Styrol/p-Hydroxystyrol (Molverhältnis 20:80) mit einem mittleren Molekulargewicht von 32.000,
2,0 Gt Hexa-N-methoxymethyl-melamin und
0,7 Gt 1-(4-Fluor-benzolsulfonyloxy)-3,4,6-trimethyl-2-pyridon in
42 Gt Propylenglykol-monomethylether-acetat.

Die Lösung wurde durch ein Filter mit einem Porendurchmesser von 0,2 µm filtriert und auf einen mit einem Haftvermittler (Hexamethyldisilazan) behandelten Wafer bei 3.000 Umdrehungen aufgeschleudert. Nach 1 min Trocknen bei 100°C auf der hot plate betrug die Schichtdicke 1,06 µm.

Das Aufzeichnungsmaterial wurde bildmäßig unter einer Vorlage mit einer Xenon-Quecksilberdampflampe unter Verwendung eines Interferenzfilters mit Strahlung von 248 ± 10 nm und einer Energie von 55 mJ/cm² belichtet, nach kurzer Lagerung 2 min auf 105°C nacherwärmt und anschließend mit dem in Beispiel 1 beschriebenen Entwickler verarbeitet.

Nach einer Entwicklungsdauer von 120 s erhielt man ein fehlerfreies Abbild der Maske mit hoher Flankenstabilität, wobei auch hier Strukturen < 0,5 µm detailgetreu aufgelöst waren.

Beispiel 3

Ein entsprechend Beispiel 1 hergestellter Wafer wurde unter Verwendung der gleichen Menge 6-(4-Chlorstyryl)-1-methansulfonyloxy-4-methyl-2-pyridon unter einer Vorlage mit UV-Licht einer Wellenlänge von 405 nm mit einer Energie von 85 mJ/cm² bestrahlt. Nach Temperung und der Entwicklung wurde ein originalgetreues negatives Abbild der Vorlage erhalten.

Beispiel 4

Der Versuch von Beispiel 3 wurde wiederholt, jedoch wurde UV-Licht einer Wellenlänge von 436 nm verwendet. Um ein negatives, kantenscharfes Abbild der Vorlage zu erhalten, war eine Belichtungsenergie von 125 mJ/cm² notwendig.

Beispiel 5

Es wurde eine Beschichtungslösung hergestellt aus

7,5 Gt eines Homopolymers aus 4-Hydroxystyrol mit einem Molekulargewicht von 18.000 und einem Erweichungsbereich von 165 bis 175°C,

2,0 Gt 4,4'-Bis-methoxymethyldiphenylether und

0,6 Gt 1-(4-Chlor-benzolsulfonyloxy)-4,5-diphenyl-2-pyridon in

42 Gt Propylenglykol-monomethylether-acetat.

Die Lösung wurde durch ein Filter mit einem Porendurchmesser von 0,2 µm filtriert und auf einen mit einem Haftvermittler (Hexamethyldisilazan) behandelten Wafer bei 3.400 Umdrehungen aufgeschleudert. Nach 1 min Trocknen bei 100°C auf der hot plate betrug die Schichtdicke 0,95 µm.

Das Aufzeichnungsmaterial wurde bildmäßig unter einer Vorlage mit einer Xenon-Quecksilberdampflampe unter Verwendung eines Interferenzfilters mit Strahlung von 248 ± 10 nm und einer Energie von 55 mJ/cm² belichtet. Das Material wurde 5 min bei Raumtemperatur gelagert und dann zur Vervollständigung der Reaktion 2 min auf 115°C erhitzt.

Entwickelt wurde das Aufzeichnungsmaterial mit einer 0,02 n wäßrigen Tetramethylammoniumhydroxidlösung, wobei die belichteten Bereiche innerhalb von 60 s rückstandsfrei abgelöst wurden.

Ein weiteres Mal wurde ein fehlerfreies negatives Abbild der Maske mit steilen Resistflanken erhalten. Der Abtrag in den belichteten Bereichen war < 10 nm; auch Strukturen < 0,5 µm waren detailgetreu aufgelöst.

Beispiel 6

Es wurde eine Beschichtungslösung hergestellt aus

7,5 Gt eines 1:1 Copolymeren aus Styrol und Maleimid mit einem Erweichungsbereich von 165 bis 180°C,

2,0 Gt Hexa-acetoxymethylmelamin,

0,8 Gt 6-Cyclohexyl-1-methansulfonyloxy-4-methyl-3-nitro-2-pyridon in

42 Gt Propylenglykol-monomethylether-acetat.

Die Lösung wurde durch ein Filter mit einem Porendurchmesser von 0,2 µm filtriert und auf einen mit einem Haftvermittler (Hexamethyldisilazan) behandelten Wafer bei 3.500 Umdrehungen aufgeschleudert. Nach 1 min Trocknen bei 100°C auf der hot plate betrug die Schichtdicke 1,05 µm.

Das Aufzeichnungsmaterial wurde bildmäßig unter einer Vorlage mit einer Xenon-Quecksilberdampflampe unter Verwendung eines Interferenzfilters mit Strahlung von 248 ± 10 nm und einer Energie von 60 mJ/cm² belichtet und wie im vorhergehenden Beispiel beschrieben getempert.

Entwickelt wurde das Aufzeichnungsmaterial mit einer 0,02 n wäßrigen Tetramethylammoniumhydroxidlösung, wobei die unbelichteten Bereiche innerhalb von 60 s rückstandsfrei abgelöst wurden. Man erhielt ein detailgetreues Abbild der Vorlage. Die Kantensteilheit des Bildes war ausgezeichnet.

Beispiel 7

Es wurde eine Beschichtungslösung hergestellt aus

7,5 Gt eines Kresol-Formaldehyd-Novolaks mit einem Erweichungsbereich von 105 bis 120°C,

2,0 Gt eines Kresol-Formaldehyd-Resols (Bakelite R5363) und

0,7 Gt 1-(4-Brom-benzolsulfonyloxy)-4-methyl-6-(4-trifluormethyl-styryl)-2-pyridon in

42 Gt Propylenglykol-monomethylether-acetat.

Die Lösung wurde durch ein Filter mit einem Porendurchmesser von 0,2 µm filtriert und auf einen mit einem Haftvermittler (Hexamethyldisilazan) behandelten Wafer bei 3.000 Umdrehungen aufgeschleudert. Nach der 1 min Trocknen bei 100°C auf der hot plate betrug die Schichtdicke 1,00 µm.

Das Aufzeichnungsmaterial wurde bildmäßig unter einer Vorlage mit der UV-Strahlung einer Xenon-Quecksilberdampflampe bei 365 nm mit einer Energie von 65 mJ/cm² belichtet, anschließend 5 min bei Raumtemperatur gelagert und dann für 90 s auf 115°C erwärmt.

Entwickelt wurde das Aufzeichnungsmaterial mit dem in Beispiel 1 beschriebenen Entwickler.

Nach einer Entwicklungsdauer von 90 s erhielt man wiederum ein negatives, fehlerfreies Abbild der Maske mit steilen, praktisch vertikalen Resistflanken, wobei auch Strukturen < 0,6 µm detailgetreu aufgelöst waren.

Beispiel 8

Es wurde eine Beschichtungslösung hergestellt aus

7,5 Gt eines Copolymeren aus Styrol/p-Hydroxystyrol (Molverhältnis 20:80) mit einem mittleren Molekulargewicht von 32.000,

2,0 Gt Hexa-N-methoxymethyl-melamin und

0,7 Gt 6-(2-Anthracen-9-yl-vinyl)-1-methansulfonyloxy-4-methyl-2-pyridon in

42 Gt Propylenglykol-monomethylether-acetat.

Die Lösung wurde durch ein Filter mit einem Porendurchmesser von 0,2 µm filtriert und auf einen mit einem Haftvermittler (Hexamethyldisilazan) behandelten Wafer bei 3.100 Umdrehungen aufgeschleudert. Nach 1 min Trocknen bei 100°C auf der hot plate betrug die Schichtdicke 1,1 µm.

Das Aufzeichnungsmaterial wurde bildmäßig unter einer Vorlage mit einer Xenon-Quecksilberdampflampe unter Verwendung eines Interferenzfilters mit Strahlung von 248 ± 10 nm und einer Energie von 35 mJ/cm² belichtet, wie im vorstehend beschriebenen Beispiel gelagert, getempert und anschließend mit dem in Beispiel 1 beschriebenen Entwickler verarbeitet.

Nach einer Entwicklungsdauer von 120 s erhielt man ein negatives fehlerfreies Abbild der Maske mit hoher Flankenstabilität, wobei auch hier Strukturen < 0,5 µm detailgetreu aufgelöst waren.

Beispiele 9 bis 11

Das vorstehend beschriebene Aufzeichnungsmaterial wurde mit Strahlung einer Wellenlänge von 365, 405 bzw. 436 nm belichtet, wobei Dosen von 42, 55 bzw. 60 mJ/cm² für eine qualitativ einwandfreie Wiedergabe der Teststrukturen bis herab zu 0,7 µm notwendig waren.

Beispiel 12

Ein entsprechend Beispiel 8 beschichteter Wafer wurde unter einer Vorlage mit UV-Licht eines KrF-Excimer-Lasers mit einer Wellenlänge von 248 nm mit einer Energie von 40 mJ/cm² bestrahlt. Der Wafer wurde dann 15 min bei Raumtemperatur gelagert und für etwa 45 s bei 110°C auf der hot plate erwärmt. Nach der Entwicklung wurde ähnlich wie in Beispiel 8 ein originalgetreues negatives Abbild der Vorlage erhalten, in dem auch Strukturen im Submikronbereich detailgetreu wiedergegeben waren.

Beispiel 13

Der Versuch von Beispiel 7 wurde wiederholt, jedoch wurde UV-Licht einer Wellenlänge von 436 nm verwendet. Um ein negatives kantenscharfes Abbild der Vorlage zu erhalten, mußte eine Belichtungsenergie von 95 mJ/cm² eingesetzt werden.

Beispiel 14

Es wurde eine Beschichtungslösung hergestellt aus

7,5 Gt eines Homopoylmeren aus 4-Hydroxystyrol mit einem Erweichungsbereich von 170 bis 180°C,
2,0 Gt Diphenylsilandiol und
0,7 Gt 1-Methansulfonyloxy-3,5-bis-methoxymethyl-4,6-dimethyl-2-pyridon in
42 Gt Propylenglykol-monomethylether-acetat.

Die Lösung wurde durch ein Filter mit einem Porendurchmesser von 0,2 µm filtriert und auf einen mit einem Haftvermittler (Hexamethyldisilazan) behandelten Wafer bei 3.200 Umdrehungen aufgeschleudert. Nach 1 min Trocknen bei 100°C auf der hot plate betrug die Schichtdicke 1,1 µm.

Das Aufzeichnungsmaterial wurde bildmäßig unter einer Vorlage mit der UV-Strahlung einer Xenon-Quecksilberdampflampe bei 260 nm mit einer Energie von 36 $mJ/cm^2$ belichtet, 5 min bei Raumtemperatur gelagert und dann für 2 min auf 105°C erwärmt.

Entwickelt wurde das Aufzeichnungsmaterial mit einer 0,14 n wäßrigen Tetramethylammoniumhydroxidlösung, wobei die unbelichteten Bereiche innerhalb von 60 s rückstandsfrei abgelöst wurden, während die belichteten Bereiche praktisch keinerlei Abtrag zeigten.

Ein weiteres Mal wurde ein fehlerfreies negatives Abbild der Maske mit zufriedenstellend steilen Resistflanken erhalten. Der Hellabtrag war nach Messung mit einem Schichtdickenmeßgerät der Fa. Rudolph < 8 nm; auch Strukturen < 0,55 µm waren detailgetreu aufgelöst.

Beispiel 15

Es wurde eine Beschichtungslösung hergestellt aus

7,5 Gt eines Homopolymeren von 3-Methyl-4-hydroxystyrol mit einem Molekulargewicht von etwa 20.000 und einem Erweichungsbereich von 145 bis 155°C,
2,0 Gt 4,4′-Bis-methoxymethyldiphenylsulfon,
0,8 Gt 3-Cyan-1-methansulfonyloxy-4,6-dimethyl-2-pyridon in
42 Gt Propylenglykol-monomethylether-acetat.

Die Lösung wurde durch ein Filter mit einem Porendurchmesser von 0,2 µm filtriert und auf einen mit einem Haftvermittler (Hexamethyldisilazan) behandelten Wafer bei 3.500 Umdrehungen aufgeschleudert. Nach 1 min Trocknen bei 100°C auf der hot plate betrug die Schichtdicke 1,06 µm.

Das Aufzeichnungsmaterial wurde bildmäßig unter einer Vorlage mit einer Xenon-Quecksilberdampflampe unter Verwendung eines Interferenzfilters mit Strahlung von 248 ± 10 nm und einer Energie von 45 $mJ/cm^2$ belichtet und enstsprechend Beispiel 1 nachgetempert.

Entwickelt wurde das Aufzeichnungsmaterial mit einer 0,27 n wäßrigen Tetramethylammoniumhydroxidlösung, wobei die unbelichteten Bereiche innerhalb von 60 s rückstandsfrei abgelöst wurden und ein detailgetreues Abbild der Vorlage vorlag. Die Kantensteilheit des Bildes betrug mehr als 88°.

Beispiel 16

Das Aufzeichnungsmaterial aus Beispiel 7 wurde mit Synchrotronstrahlung (BESSY, Berlin, 754 MeV) durch eine Gold-auf-Silicium-Maske mit einer Dosis von 200 $mJ/cm^2$ bestrahlt. Den experimentellen Aufbau findet man bei A. Heuberger, Microelectr. Eng., 3, 535 (1985). Das Material wurde etwa 10 min bei Raumtemperatur gelagert und dann 2 min auf 110°C erwärmt. Nach Entwicklung mit dem in Beispiel 11 beschriebenen Entwickler und einer Entwicklungsdauer von 70 s erhielt man ein fehlerfreies negatives Bild der Maske bis herab zu Strukturen von < 0,4 µm. Die Resistflanken waren praktisch senkrecht zur planaren Substratoberfläche.

Beispiele 17 und 18 (Vergleichsbeispiele)

Die Resistformulierung des Beispiels 14 wurde derart abgeändert, daß die dort verwendete säurebildende Verbindung bindung durch die gleiche Menge an Triphenylsulfoniumhexafluorphosphat (Beispiel 17) oder 2-Nitrobenzyltosylat (Beispiel 18) ersetzt wurde. Nach einer Belichtung mit Strahlung einer Wellenlänge von 260 nm und einer Energie von 95 bzw. 115 $mJ/cm^2$ sowie Temperung und Entwicklung mit einem Entwickler der in Beispiel 14 angegebenen Zusammensetzung erhielt man Strukturen, die keine praxisgerechte Bilddifferenzierung zeigten.

Bei Verwendung des Onium-Salzes (Beispiel 17) wurden auch in den unbelichteten Bereichen Lackreste beobachtet, d.h. Resistreste hafteten in den unbelichteten Bereichen am Substrat an, während bei Verwendung des Tosylesters (Beispiel 18) unterschnittene Resistprofile sichtbar waren, die auch bei verstärkter Belichtung nur auf Kosten der Wiedergabegenauigkeit beseitigt werden konnten. In beiden Fällen konnten keine akzeptablen Strukturierungen erhalten werden.

Beispiel 19

Für die Herstellung einer Offsetdruckplatte wurde eine mechanisch aufgerauhte und vorbehandelte Aluminiumfolie mit einer Beschichtungslösung nachstehender Zusammensetzung schleuderbeschichtet:

7,5 Gt eines Kresol-Formaldehyd-Novolaks mit einem Erweichungsbereich von 105 bis 120°C,
2,3 Gt eines Kresol/Formaldehyd Resols (Bakelite R 5363),
0,5 Gt 6-(4-Chlorstyryl)-1-methansulfonyloxy-4-methyl-2-pyridon und
0,05 Gt Kristallviolettbase in
90 Gt Propylenglykol-monomethylether-acetat.

Nach dem Trocknen der Schicht (Schichtgewicht ca. 2,5 g/$m^2$) wurde unter einer negativen Testvorlage 30 s belichtet und die Platte nach 10 minütiger Lagerung für 2 min in einem Umluftofen mit einer Temperatur von 115°C erwärmt. Es wurde mit einem Entwickler folgender Zusammensetzung entwickelt:

0,5 Gt Natriumhydroxid,
0,8 Gt Natriummetasilikat x 9 $H_2O$ und
1,0 Gt 2-n-Butoxy-ethanol in
97,7 Gt vollentsalztem Wasser.

Bei der Entwicklung wurde eine detailgetreue inverse Wiedergabe der Vorlage sichtbar. Nach Abspülen mit Wasser wurde die Platte durch Überwischen mit 1%iger Phosphorsäure druckfertig gemacht. Nach dem Einspannen in eine Druckmaschine wurden 175.000 einwandfreie Drucke erhalten.

Beispiel 20

Die Lösung eines Ätz- und Galvanonegativtrockenresists wurde aus nachstehender Zusammensetzung hergestellt:

12,5 Gt des in Beispiel 16 beschriebenen Novolaks,
10,0 Gt Hexa-N-methoxymethyl-melamin,
0,5 Gt 6-(2,2-Diphenyl-vinyl)-1-methansulfonyloxy-4-methyl-2-pyridon und
0,1 Gt Kristallviolett in
30 Gt Butanon.

Eine für diesen Zweck übliche Polyethylenterephthalatfolie von 25 µm Dicke wurde mit dieser Lösung beschichtet, so daß sich eine Trockenschichtdicke von 18 µm ergab. Die Oberfläche des trockenen Resistfilms wurde mit einer weiteren Polyethylenterephthalatfolie kaschiert. Der Trockenfilm wurde nach Abziehen der Deckfolie unter Druck und Wärme auf ein Messingblech auflaminiert. Nach Abkühlen und Abziehen der Trägerfolie wurde das Blech durch eine Vorlage hindurch belichtet, wobei nach kurzer Erwärmung ein guter Bildkontrast sichtbar wurde. Das Material wurde 10 min gelagert und dann für 4 min auf 100°C erwärmt. Die unbelichteten Stellen wurden mit einem Entwickler der in Beispiel 18 angegebenen Zusammensetzung sprühentwickelt. Das Blech wurde anschließend mit einer handelsüblichen Eisen-III-chlorid-Lösung bis hin zu den glatten Flanken durchgeätzt. Die erhaltenen Formteile können vor dem Trennen noch weiter bearbeitet werden.

## Patentansprüche

1. Negativ arbeitendes strahlungsempfindliches Gemisch mit
   a) einer Verbindung, die unter Einwirkung von aktinischer Strahlung eine starke Säure bildet,
   b) einer Verbindung mit mindestens zwei durch Säure vernetzbaren Gruppen und
   c) einem in Wasser unlöslichen, in wäßrig-alkalischen Lösungen löslichen oder zumindest quellbaren polymeren Bindemittel,

   das dadurch gekennzeichnet ist, daß die Verbindung (a) ein 1-Sulfonyloxy-2-pyridon der allgemeinen Formel I

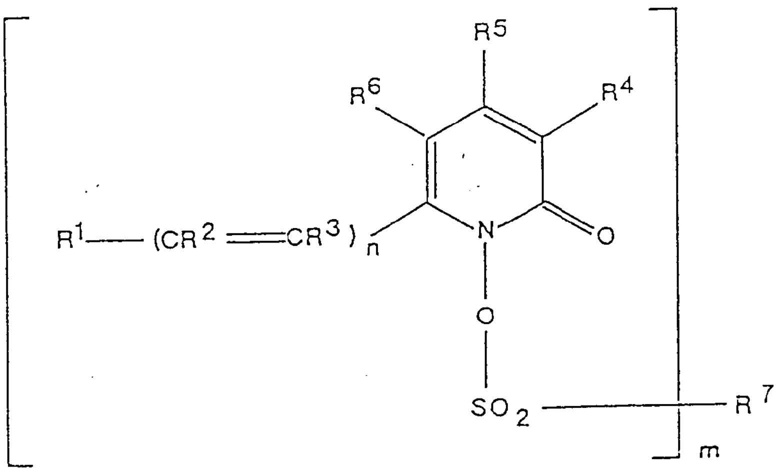

(I)

ist, worin

| | |
|---|---|
| $R^1$ | ein Wasserstoffatom, einen Alkyl-, Cycloalkyl-, Aryl-, Ferrocenyl-, Aralkenyl-, Heteroaryl- oder Heteroaralkenylrest, |
| $R^2$ | Wasserstoff, Chlor, Brom, einen Alkyl-, Cycloalkyl-, Aryl- oder Heteroarylrest oder |
| $R^1$ und $R^2$ | gemeinsam einen fünf- bis achtgliedrigen Ring ausbilden, |
| $R^3$ | Wasserstoff oder einen Alkylrest, |
| $R^4$ | Wasserstoff, Halogen, Nitro, Acylamino, Cyan, Thiocyanato, einen Alkyl-, Alkenyl-, Alkinyl-, Aryl-, Aralkyl-, Alkylthio-, Arylthio- oder Cycloalkylthiorest, |
| $R^5$ | Wasserstoff, einen Alkyl- oder Arylrest oder |
| $R^4$ und $R^5$ | zusammen einen fünf- bis achtgliedrigen Ring ausbilden, |
| $R^6$ | Wasserstoff, Halogen, Nitro, Acylamino, Cyan, Thiocyanato, einen Alkyl-, Alkenyl-, Alkoxyalkyl-, Aryl-, Aralkyl-, Alkylthio-, Cycloalkylthio- oder Arylthiorest, |
| $R^7$ | einen Alkyl-, Cycloalkyl, per- oder hochfluorierten Alkylrest oder einen Aryl-, Arylalkyl- oder Heteroarylrest oder einen Alkylen- oder Arylenrest |
| m | die Zahl 1 oder 2 und |
| n | eine ganze Zahl von 0 bis 3 |

bedeuten.

2. Negativ arbeitendes strahlungsempfindliches Gemisch gemäß Anspruch 1, dadurch gekennzeichnet, daß
$R^1$ ein Alkyl- oder Cycloalkylrest oder ein Arylrest der allgemeinen Formel II

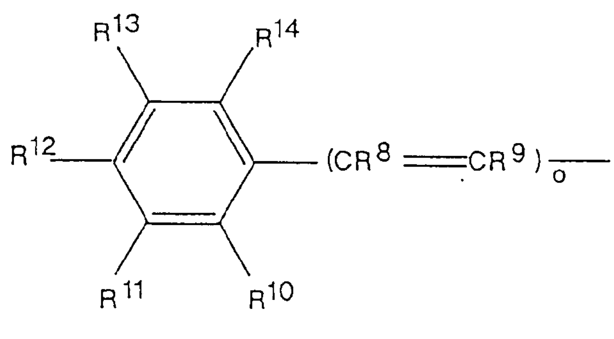

(II)

ist, worin

| | |
|---|---|
| $R^8$ und $R^9$ | gleich oder verschieden sind und Wasserstoff, eine niedere Alkyl- oder Arylgruppe darstellen, |
| $R^{10}$ bis $R^{14}$ | gleich oder verschieden sind und Wasserstoff, einen Alkyl-, Alkenyl-, Alkoxy-, Alkylthio-, Alkansulfonylrest mit jeweils bis zu 6 Kohlenstoffatomen, einen Cycloalkyloxy-, Cycloalkylthio-, Cycloalkansulfonylrest mit bis zu 8 Kohlenstoffatomen, gegebenenfalls am aromatischen Ring substituierten Phenyl-, Styryl-, Phenoxy-, Phenylthio-, Benzolsulfonyl-, Phenylalkoxy-, Phenylalkylthio-, Phe- |

nylalkansulfonylrest mit bis zu 3 Kohlenstoffatomen in der Alkylkette, Hydroxy, Halogen, Trifluormethyl, Nitro, Cyan, Alkoxycarbonyl, Carbamoyl, das gegebenenfalls am Stickstoff durch einen oder zwei Alkylrest(e), die gegebenenfalls zu einem 5- bis 7-gliedrigen Ring verbunden sind, substituiert ist, Sulfamoyl, das gegebenenfalls am Stickstoff durch ein oder zwei Alkylrest(e), die gegebenenfalls zu einem 5- bis 7-gliedrigen Ring verbunden sind, substituiert ist, Alkansulfonyloxy, Arylsulfonyloxy, Acylamino, Alkylamino oder Arylamino bedeuten,
oder zwei der Substituenten $R^{10}$ bis $R^{14}$, die einander benachbart sind, einen oder zwei weitere ankondensierte Ring(e) bilden, und

o für die Zahl 0 oder 1 steht.

3. Negativ arbeitendes strahlungsempfindliches Gemisch gemäß den Ansprüchen 1 oder 2, dadurch gekennzeichnet, daß $R^1$ ein 5- oder 6-gliedriger Heterocyclus mit bis zu drei Heteroatomen der allgemeinen Formel III

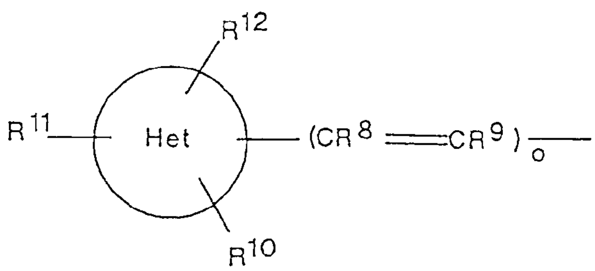

(III)

ist.

4. Negativ arbeitendes strahlungsempfindliches Gemisch gemäß Anspruch 1, dadurch gekennzeichnet, daß in der allgemeinen Formel I

| | |
|---|---|
| $R^1$ | ein Ferrocenylrest und |
| $R^2$ | Wasserstoff, Chlor, Brom, Alkyl-, Cycloalkyl oder ein Rest der allgemeinen Formeln II oder III ist oder |
| $R^1$ und $R^2$ | gemeinsam einen fünf- bis achtgliedrigen Ring ausbilden, |
| $R^3$ | Wasserstoff oder ein Alkylrest, |
| $R^4$ | Wasserstoff, Halogen, Nitro, Acylamino, Cyan, Thiocyanato, ein Alkyl-, Aryl-, Alkylthio-, Arylthio- oder Cycloalkylthiorest, |
| $R^5$ | Wasserstoff, ein Alkyl- oder Arylrest ist oder |
| $R^4$ und $R^5$ | gemeinsam einen fünf- bis achtgliedrigen Ring ausbilden, |
| $R^6$ | Wasserstoff, Halogen, Nitro, Acylamino, Cyan, Thiocyanato, ein Alkyl-, Aryl-, Alkylthio-, Arylthio- oder Cycloalkylthiorest, |
| $R^7$ | ein Alkyl-, Cycloalkyl-, per- oder hochfluorierten Alkylrest oder ein Aryl-, Arylalkyl-, oder Heteroarylrest oder ein Alkylen- oder Arylenrest ist und |
| m | für die Zahl 1 oder 2 und |
| n | für eine ganze Zahl von 0 bis 3 steht. |

5. Negativ arbeitendes strahlungsempfindliches Gemisch gemäß Anspruch 1, dadurch gekennzeichnet, daß $R^7$ ein Alkylrest mit 1 bis 4 Kohlenstoffatomen, ein hoch- oder perfluorierter Alkylrest mit 1 bis 4 Kohlenstoffatomen oder ein Arylrest der allgemeinen Formel IV

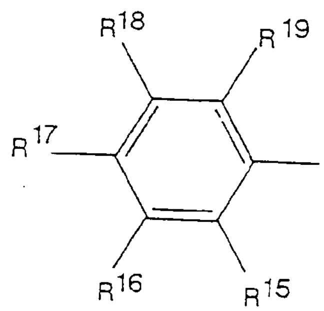

(IV)

ist, worin $R^{15}$ bis $R^{19}$ gleich oder verschieden sind und Wasserstoff- oder Halogenatome, die vorzugsweise Fluor, Chlor oder Brom sind, Alkylreste mit bis zu 6 Kohlenstoffatomen, die unsubstituiert oder durch Halogenatome, vorzugsweise Chlor oder Brom, Aryl- oder Aryloxyreste, substituiert sind und in denen einzelne Methylengruppen durch Sauerstoff- oder Schwefelatome ersetzt sein können und wobei jeweils zwei dieser Reste unter Ausbildung eines 5- oder 6-gliedrigen Rings verknüpft sein können, Cycloalkylreste mit bis zu 8 Kohlenstoffatomen, Alkenylreste mit bis zu 6 Kohlenstoffatomen, Aryl- oder Aryloxyreste mit bis zu 10 Kohlenstoffatomen bedeuten und die Gesamtzahl der Kohlenstoffatome der Reste $R^{15}$ bis $R^{19}$ maximal 12 beträgt.

6. Negativ arbeitendes strahlungsempfindliches Gemisch gemäß Anspruch 1, dadurch gekennzeichnet, daß $R^7$ ein Naphthyl- oder Heteroarylrest mit bis zu 10 Kohlenstoffatomen, ein Alkylenrest mit bis zu 6 Kohlenstoffatomen oder ein Arylen- oder Heteroarylenrest mit bis zu 14 Kohlenstoffatomen ist.

7. Negativ arbeitendes strahlungsempfindliches Gemisch gemäß Anspruch 1, dadurch gekennzeichnet, daß

| | |
|---|---|
| $R^2$, $R^3$, $R^4$ und $R^6$ | ein Wasserstoffatom, |
| $R^5$ | eine Methylgruppe, |
| $R^7$ | einen Methyl-, Ethyl-, Trifluormethyl-, 1,1,2,3,3,3-Hexafluorpropyl-, Phenyl-, Tolyl-, 4-Fluorphenyl-, 4-Chlorphenyl-, 4-Bromphenyl oder 4-Nitrophenylrest, |
| n | die Zahl 0 oder 1 und |
| m | die Zahl 1 |

bedeuten.

8. Negativ arbeitendes strahlungsempfindliches Gemisch, gemäß einem oder mehreren der Ansprüche 1 bis 7, dadurch gekennzeichnet, daß der Anteil der säurebildenden Verbindung a) 0,5 bis 25 Gew.-%, bevorzugt 1,0 bis 15 Gew.-%, jeweils bezogen auf das Gesamtgewicht der Feststoffe des strahlungsempfindlichen Gemisches, beträgt.

9. Negativ arbeitendes strahlungsempfindliches Gemisch gemäß einem oder mehreren der Ansprüche 1 bis 8, dadurch gekennzeichnet, daß die Extinktion des Bindemittels bzw. der Kombination von Bindemitteln für Strahlung der Wellenlänge von etwa 220 bis 500 nm weniger als 0,5, bevorzugt weniger als 0,3 $\mu m^{-1}$ beträgt.

10. Negativ arbeitendes strahlungsempfindliches Gemisch gemäß einem oder mehreren der Ansprüche 1 bis 9, dadurch gekennzeichnet, daß das Bindemittel c) phenolische Hydroxygruppen enthält.

11. Negativ arbeitendes strahlungsempfindliches Gemisch gemäß Anspruch 10, dadurch gekennzeichnet, daß das Bindemittel c) bis zu 30 Gew.-%, insbesondere bis zu 20 Gew.-%, eines Novolak-Kondensationsharzes enthält.

12. Negativ arbeitendes strahlungsempfindliches Gemisch gemäß einem oder mehreren der Ansprüche 9 bis 11, dadurch gekennzeichnet, daß der Anteil des Bindemittels c) 30 bis 95 Gew.-%, bevorzugt 40 bis 90 Gew.-%, besonders bevorzugt 50 bis 85 Gew.-%, jeweils bezogen auf das Gesamtgewicht der Feststoffe des strahlungsempfindlichen Gemisches, beträgt.

13. Negativ arbeitendes strahlungsempfindliches Gemisch gemäß einem oder mehreren der Ansprüche 1 bis 12, dadurch gekennzeichnet, daß die vernetzbare Verbindung b) ein Resol ist.

**14.** Negativ arbeitendes strahlungsempfindliches Gemisch gemäß einem oder mehreren der Ansprüche 1 bis 13, dadurch gekennzeichnet, daß die vernetzbare Verbindung b) ein alkoxymethyl- oder glycidylsubstituierter Aromat oder ein Melamin/Formaldehyd- oder Harnstoff/Formaldehyd-Kondensat ist.

**15.** Negativ arbeitendes strahlungsempfindliches Gemisch gemäß Anspruch 1, dadurch gekennzeichnet, daß die 1-Sulfonyloxy-2-pyridone eine höhere molare Absorption für Strahlung der Wellenlänge 220 bis 500 nm aufweisen als die übrigen Bestandteile des Gemisches.

**16.** Negativ arbeitendes strahlungsempfindliches Aufzeichungsmaterial aus einem Träger und einer strahlungsempfindlichen Schicht, dadurch gekennzeichnet, daß die Schicht aus einem strahlungshärtbaren Gemisch gemäß Ansprüchen 1 bis 15 besteht.

**17.** Verfahren zur Herstellung eines Bildmusters, dadurch gekennzeichnet, daß das Aufzeichnungsmaterial gemäß Anspruch 16 bildmäßig bestrahlt, erwärmt und anschließend entwickelt wird, wobei die unbelichteten Bereiche des Materials gelöst bzw. entfernt werden.

**18.** Verfahren gemäß Anspruch 17, dadurch gekennzeichnet, daß das Aufzeichnungsmaterial mit Strahlung einer Wellenlänge von 150 bis 550 nm, bevorzugt 200 bis 450 nm, besonders bevorzugt 240 bis 440 nm, verwendet wird.

## Claims

**1.** A negative-working radiation-sensitive mixture with

a) a compound which generates a strong acid under the action of actinic radiation,

b) a compound having at least two groups cross-linkable by acid and

c) a polymeric binder which is insoluble in water and soluble or at least swellable in aqueous alkaline solutions,

wherein the compound a) is a 1-sulfonyloxy-2-pyridone of the formula (I)

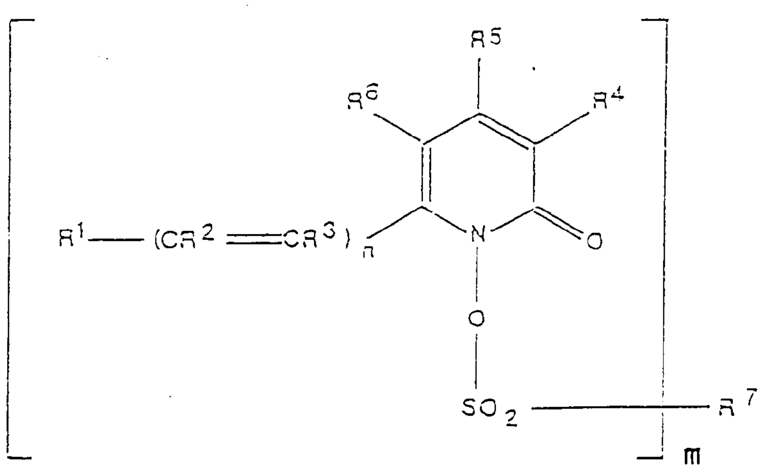

(I)

in which

| | |
|---|---|
| $R^1$ | is a hydrogen atom or an alkyl, cycloalkyl, aryl, ferrocenyl, aralkenyl, heteroaryl or heteroaralkenyl radical, |
| $R^2$ | is hydrogen, chlorine, bromine or an alkyl, cycloalkyl, aryl or heteroaryl radical, or |
| $R^1$ and $R^2$ | together form a five- to eight-membered ring, |
| $R^3$ | is hydrogen or an alkyl radical, |
| $R^4$ | is hydrogen, halogen, nitro, acylamino, cyano, thiocyanato or an alkyl, alkenyl, alkynyl, aryl, aralkyl, alkylthio, arylthio or cycloalkylthio radical, |
| $R^5$ | is hydrogen or an alkyl or aryl radical or |
| $R^4$ and $R^5$ | together form a five- to eight-membered ring, |
| $R^6$ | is hydrogen, halogen, nitro, acylamino, cyano, thiocyanato or an alkyl, alkenyl, alkoxyalkyl, aryl, aralkyl, alkylthio, cycloalkylthio or arylthio radical, |

$R^7$ is an alkyl or cycloalkyl radical, a perfluorinated or highly fluorinated alkyl radical or an aryl, arylalkyl or heteroaryl radical or an alkylene or arylene radical,

m is the number 1 or 2 and

n is an integer from 0 to 3.

2. A negative-working radiation-sensitive mixture as claimed in claim 1, wherein

$R^1$ is an alkyl or cycloalkyl radical or an aryl radical of the formula II

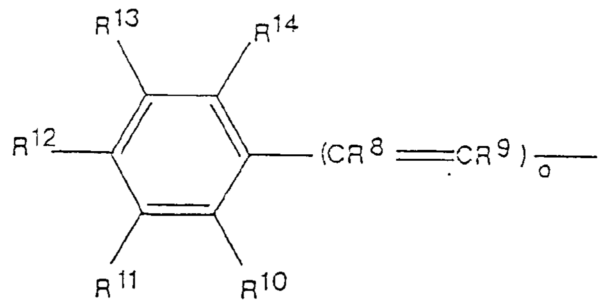

(II)

in which

$R^8$ and $R^9$ are identical or different and are hydrogen or a lower alkyl or aryl group,

$R^{10}$ to $R^{14}$ are identical or different and are hydrogen, an alkyl, alkenyl, alkoxy, alkylthio or alkanesulfonyl radical each having up to 6 carbon atoms, a cycloalkyloxy, cycloalkylthio or cycloalkanesulfonyl radical having up to 8 carbon atoms, a phenyl, styryl, phenoxy, phenylthio, benzenesulfonyl, phenylalkoxy, phenylalkylthio or phenylalkanesulfonyl radical which may be substituted on the aromatic ring and has up to 3 carbon atoms in the alkyl chain, hydroxy, halogen, trifluoromethyl, nitro, cyano, alkoxycarbonyl, carbamoyl which may be substituted on the nitrogen by one or two alkyl radical(s) which may be linked to form a 5- to 7-membered ring, sulfamoyl which may be substituted on the nitrogen by one or two alkyl radical(s) which may be linked to form a 5- to 7-membered ring, alkanesulfonyloxy, arylsulfonyloxy, acylamino, alkylamino or arylamino, or two mutually adjacent substituents $R^{10}$ to $R^{14}$ form one or two further fused ring(s), and

o is the number 0 or 1.

3. A negative-working radiation-sensitive mixture as claimed in claim 1 or 2, wherein $R^1$ is a 5- or 6-membered heterocyclic ring having up to three heteroatoms, of the formula III

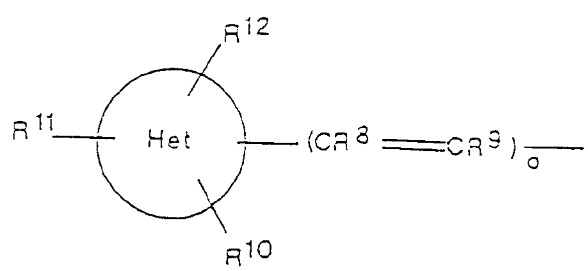

(III)

4. A negative-working radiation-sensitive mixture as claimed in claim 1, wherein

$R^1$ is a ferrocenyl radical and

$R^2$ is hydrogen, chlorine, bromine, alkyl, cycloalkyl or a radical of the formula II or III or

$R^1$ and $R^2$ together form a five- to eight-membered ring,

$R^3$ is hydrogen or an alkyl radical,

$R^4$ is hydrogen, halogen, nitro, acylamino, cyano, thiocyanato or an alkyl, aryl, alkylthio, arylthio or cycloalkylthio radical,

$R^5$ is hydrogen or an alkyl or aryl radical or

$R^4$ and $R^5$ together form a five- to eight-membered ring,

$R^6$ is hydrogen, halogen, nitro, acylamino, cyano, thiocyanato or an alkyl, aryl, alkylthio, ar-

ylthio or cycloalkylthio radical,

$R^7$ is an alkyl or cycloalkyl radical, a perfluorinated or highly fluorinated alkyl radical or an aryl, arylalkyl or heteroaryl radical or an alkylene or arylene radical and

m is the number 1 or 2 and

n is an integer from 0 to 3.

**5.** A negative-working radiation-sensitive mixture as claimed in claim 1, wherein $R^7$ is an alkyl radical having 1 to 4 carbon atoms, a highly fluorinated or perfluorinated alkyl radical having 1 to 4 carbon atoms or an aryl radical of the formula IV

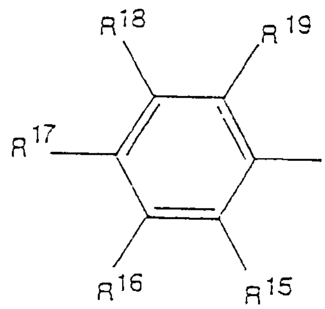

(IV)

in which $R^{15}$ to $R^{19}$ are identical or different and are hydrogen atoms or halogen atoms, preferably fluorine, chlorine or bromine, alkyl radicals which have up to 6 carbon atoms and are unsubstituted or substituted by halogen atoms, preferably chlorine or bromine, aryl or aryloxy radicals and in which individual methylene groups can be replaced by oxygen or sulfur atoms and in which in each case two of these radicals can be linked to form a 5- or 6-membered ring, cycloalkyl radicals having up to 8 carbon atoms, alkenyl radicals having up to 6 carbon atoms or aryl or aryloxy radicals having up to 10 carbon atoms, the total number of the carbon atoms in the radicals $R^{15}$ to $R^{19}$ being not more than 12.

**6.** A negative-working radiation-sensitive mixture as claimed in claim 1, wherein $R^7$ is a naphthyl or heteroaryl radical having up to 10 carbon atoms, an alkylene radical having up to 6 carbon atoms or an arylene or heteroarylene radical having up to 14 carbon atoms.

**7.** A negative-working radiation-sensitive mixture as claimed in claim 1, wherein

$R^2$, $R^3$, $R^4$ and $R^6$ are a hydrogen atom,

$R^5$ is a methyl group,

$R^7$ is a methyl, ethyl, trifluoromethyl, 1,1,2,3,3,3-hexafluoropropyl, phenyl, tolyl, 4-fluorophenyl, 4-chlorophenyl, 4-bromophenyl or 4-nitrophenyl radical,

m is the number 1 and

n is the number 0 or 1.

**8.** A negative-working radiation-sensitive mixture as claimed in one or more of claims 1 to 7, wherein the content of the acid-generating compound a) is 0.5 to 25% by weight, preferably 1.0 to 15% by weight, each relative to the total weight of the solids in the radiation-sensitive mixture.

**9.** A negative-working radiation-sensitive mixture as claimed in one or more of claims 1 to 8, wherein the extinction of the binder or of the combination of binders for radiation of wavelength from about 220 to 500 nm is less than 0.5, preferably less than 0.3 $\mu m^{-1}$.

**10.** A negative-working radiation-sensitive mixture as claimed in one or more of claims 1 to 9, wherein the binder c) contains phenolic hydroxy groups.

**11.** A negative-working radiation-sensitive mixture as claimed in claim 10, wherein the binder c) contains up to 30% by weight, especially up to 20% by weight, of a novolak condensation resin.

**12.** A negative-working radiation-sensitive mixture as claimed in one or more of claims 9 to 11, wherein the content of binder c) is 30 to 95% by weight, preferably 40 to 90% by weight, particularly preferably 50 to 85% by weight, each relative to the total weight of the solids in the radiation-sensitive mixture.

13. A negative-working radiation-sensitive mixture as claimed in one or more of claims 1 to 12, wherein the crosslinkable compound b) is a resol.

14. A negative-working radiation-sensitive mixture as claimed in one or more of claims 1 to 13, wherein the crosslinkable compound b) is an alkoxymethyl- or glycidyl-substituted aromatic compound or a melamine/formaldehyde or urea/formaldehyde condensate.

15. A negative-working radiation-sensitive mixture as claimed in claim 1, wherein the 1-sulfonyloxy-2-pyridone has a higher molar absorption for radiation of the wavelength 220 to 500 nm than the remaining constituents of the mixture.

16. A negative-working radiation-sensitive recording material composed of a support and a radiation-sensitive layer, wherein the layer comprises a radiation-curable mixture as claimed in any of claims 1 to 15.

17. A method for preparing an image pattern, which comprises irradiating the recording material as claimed in claim 16 image-wise, heating and then developing it, the unexposed areas of the material being dissolved or removed.

18. The method as claimed in claim 17, wherein the recording material is used with radiation of a wavelength from 150 to 550 nm, preferably 200 to 450 nm, particularly preferably 240 to 440 nm.

## Revendications

1. Composition sensible aux radiations, travaillant en négatif, comportant
   a) un composé qui forme un acide fort sous l'effet d'un rayonnement actinique,
   b) un composé comportant au moins deux groupes réticulables par un acide et
   c) un liant polymère insoluble dans l'eau et soluble ou au moins susceptible de gonfler dans des solutions aqueuses-alcalines,

   caractérisée en ce que le composé a) est une 1-sulfonyloxy-2-pyridone de formule générale I

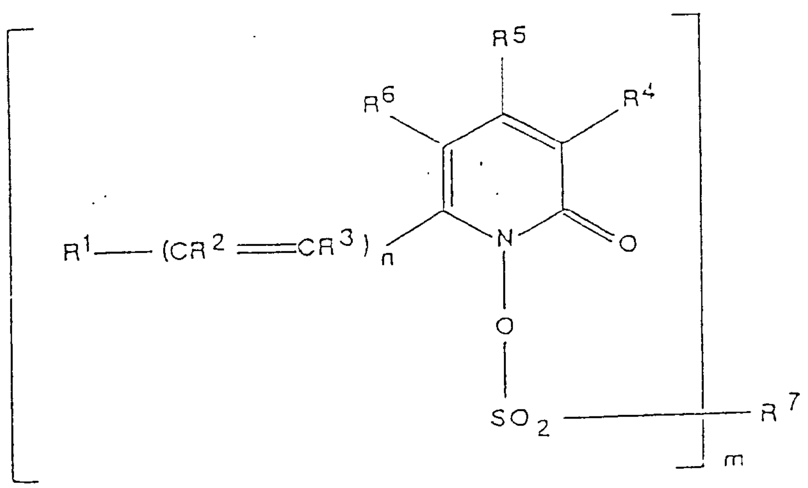

(I)

dans laquelle

| | |
|---|---|
| $R^1$ | représente un atome d'hydrogène ou un radical alkyle, cycloalkyle, aryle, ferrocényle, aralcényle, hétéroaryle ou hétéroaralcényle, |
| $R^2$ | représente un atome d'hydrogène, de chlore ou de brome, ou un radical alkyle, cycloalkyle, aryle ou hétéroaryle, ou |
| $R^1$ et $R^2$ | forment ensemble un cycle à 5-8 chaînons, |
| $R^3$ | représente un atome d'hydrogène ou un radical alkyle, |
| $R^4$ | représente un atome d'hydrogène ou d'halogène ou un radical nitro, acylamino, cyano, thiocyanato, alkyle, alcényle, alcynyle, aryle, aralkyle, alkylthio, arylthio ou cycloalkylthio, |
| $R^5$ | représente un atome d'hydrogène ou un radical alkyle ou aryle, ou |

| | |
|---|---|
| $R^4$ et $R^5$ | forment ensemble un cycle à 5-8 chaînons, |
| $R^6$ | représente un atome d'hydrogène ou d'halogène, ou un radical nitro, acylamino, cyano, thiocyanato, alkyle, alcényle, alcoxyalkyle, aryle, aralkyle, alkylthio, cycloalkylthio ou arylthio, |
| $R^7$ | représente un radical alkyle, cycloalkyle, un radical alkyle perfluoré ou hautement fluoré, ou un radical aryle, arylalkyle ou hétéroaryle, ou un radical alkylène ou arylène, |
| m | représente le nombre 1 ou 2 et |
| n | représente un nombre entier allant de 0 à 3. |

**2.** Composition sensible aux radiations, travaillant en négatif, selon la revendication 1, caractérisée en ce que

$R^1$ est un radical alkyle ou cycloalkyle ou un radical aryle de formule générale II

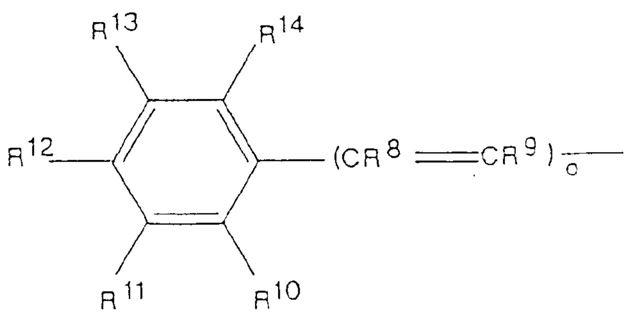

(II)

dans laquelle

| | |
|---|---|
| $R^8$ et $R^9$ | sont identiques ou différents et représentent un atome d'hydrogène ou un groupe alkyle inférieur ou aryle, |
| $R^{10}$ à $R^{14}$ | sont identiques ou différents et représentent un atome d'hydrogène ou d'halogène ou un radical alkyle, alcényle, alcoxy, alkylthio, alcanesulfonyle ayant chacun jusqu'à 6 atomes de carbone, un radical cycloalkyloxy, cycloalkylthio, cycloalcanesulfonyle ayant jusqu'à 8 atomes de carbone, un radical phényle éventuellement substitué sur le noyau aromatique, un radical styryle, phénoxy, phénylthio, benzène-sulfonyle, phénylalcoxy, phénylalkylthio, phénylalcanesulfonyle ayant jusqu'à 3 atomes de carbone dans la chaîne alkyle, hydroxy, trifluorométhyle, nitro, cyano, alcoxycarbonyle, un radical carbamoyle qui est éventuellement substitué sur l'atome d'azote par un ou deux restes alkyle qui sont éventuellement liés à un cycle à 5 à 7 chaînons, un radical sulfamoyle qui est éventuellement substitué sur l'atome d'azote par un ou deux restes alkyle qui sont éventuellement liés à un cycle à 5-7 chaînons, un radical alcanesulfonyloxy, arylsulfonyloxy, acylamino, alkylamino ou arylamino, ou deux des substituants $R^{10}$ à $R^{14}$, qui sont voisins l'un de l'autre, forment un ou deux autres cycles condensés, et |
| o | représente le nombre 0 ou 1. |

**3.** Composition sensible aux radiations, travaillant en négatif, selon la revendication 1 ou 2, caractérisée en ce que $R^1$ est un hétérocycle à 5 ou 6 chaînons et comporte jusqu'à 3 hétéroatomes, de formule générale III

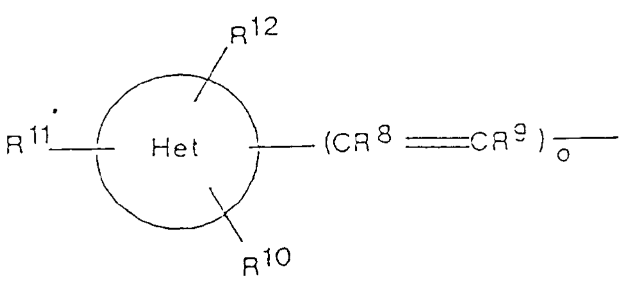

(III)

4. Composition sensible aux radiations, travaillant en négatif, selon la revendication 1, caractérisée en ce que, dans la formule générale I,

| | |
|---|---|
| $R^1$ | est le radical ferrocényle et |
| $R^2$ | est un atome d'hydrogène, de chlore ou de brome ou un radical alkyle ou cycloalkyle, ou un radical de formule générale II ou III, ou |
| $R^1$ et $R^2$ | forment ensemble un cycle à 5-8 chaînons, |
| $R^3$ | est un atome d'hydrogène ou un radical alkyle, |
| $R^4$ | est un atome d'hydrogène ou d'halogène ou un radical nitro, acylamino, cyano, thiocyanato, alkyle, aryle, alkylthio, arylthio ou cycloalkylthio, |
| $R^5$ | est un atome d'hydrogène ou un radical alkyle ou aryle, ou |
| $R^4$ et $R^5$ | forment ensemble un cycle à 5-8 chaînons, |
| $R^6$ | est un atome d'hydrogène ou d'halogène ou un radical nitro, acylamino, cyano, thiocyanato, alkyle, aryle, arylthio, alkylthio ou cycloalkylthio, |
| $R^7$ | est un radical alkyle, cycloalkyle, un radical alkyle perfluoré ou hautement fluoré, ou un radical aryle, arylalkyle ou hétéroaryle ou un radical alkylène ou arylène, et |
| m | est le nombre 1 ou 2, et |
| n | représente un nombre entier allant de 0 à 3. |

5. Composition sensible aux radiations, travaillant en négatif, selon la revendication 1, caractérisée en ce que $R^7$ est un radical alkyle ayant de 1 à 4 atomes de carbone, un radical alkyle hautement fluoré ou perfluoré, ayant de 1 à 4 atomes de carbone, ou un radical aryle de formule générale IV

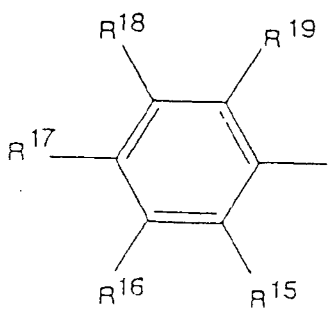

(IV)

dans laquelle $R^{15}$ à $R^{19}$ sont identiques ou différents et représentent des atomes d'hydrogène ou d'halogène, qui sont de préférence des atomes de fluor, de chlore ou de brome, ou des radicaux alkyle ayant jusqu'à 6 atomes de carbone, qui ne sont pas substitués ou sont substitués par des atomes d'halogène, de préférence de chlore ou de brome, ou par des radicaux aryle ou aryloxy, et dans lesquels des groupes méthylène individuels peuvent être remplacés par des atomes d'oxygène ou de soufre, et chaque fois deux de ces restes pouvant être liés avec formation d'un cycle à 5 ou 6 chaînons, ou des radicaux cycloalkyle ayant jusqu'à 8 atomes de carbone, alcényle ayant jusqu'à 6 atomes de carbone, aryle ou aryloxy ayant jusqu'à 10 atomes de carbone et le nombre total des atomes de carbone des radicaux $R^{15}$ à $R^{19}$est au maximum 12.

6. Composition sensible aux radiations, travaillant en négatif, selon la revendication 1, caractérisée en ce que $R^7$ est un radical naphtyle ou hétéroaryle ayant jusqu'à 10 atomes de carbone, un radical alkylène ayant jusqu'à 6 atomes de carbone, ou un radical arylène ou hétéroarylène ayant jusqu'à 14 atomes de carbone.

7. Composition sensible aux radiations, travaillant en négatif, selon la revendication 1, caractérisée en ce que

| | |
|---|---|
| $R^2$, $R^3$, $R^4$ et $R^6$ | représentent un atome d'hydrogène, |
| $R^5$ | représente le groupe méthyle, |
| $R^7$ | représente le radical méthyle, éthyle, trifluorométhyle, 1,1,2,3,3,3-hexafluoropropyle, phényle, tolyle, 4-fluorophényle, 4-chlorophényle, 4-bromophényle ou 4-nitrophényle, |
| n | représente le nombre 0 ou 1, et |
| m | représente le nombre 1. |

**8.** Composition sensible aux radiations, travaillant en négatif, selon une ou plusieurs des revendications 1 à 7, caractérisée en ce que la proportion du composé a) formant un acide va de 0,5 à 25 % en poids, de préférence de 1,0 à 15 % en poids, dans chaque cas par rapport au poids total des matières sèches de la composition sensible aux radiations.

**9.** Composition sensible aux radiations, travaillant en négatif, selon une ou plusieurs des revendications 1 à 8, caractérisée en ce que l'extinction du liant ou du mélange de liants, pour un rayonnement de longueur d'onde d'environ 220 à 500 nm, est inférieure à 0,5, de préférence inférieure à 0,3 $\mu m^{-1}$.

**10.** Composition sensible aux radiations, travaillant en négatif, selon une ou plusieurs des revendications 1 à 9, caractérisée en ce que le liant c) comporte des groupes hydroxy phénoliques.

**11.** Composition sensible aux radiations, travaillant en négatif, selon la revendication 10, caractérisée en ce que le liant c) contient jusqu'à 30 % en poids, en particulier jusqu'à 20 % en poids, d'une résine de condensation Novolaque.

**12.** Composition sensible aux radiations, travaillant en négatif, selon une ou plusieurs des revendications 9 à 11, caractérisée en ce que la proportion du liant c) va de 30 à 95 % en poids, de préférence de 40 à 90 % en poids, en particulier de 50 à 85 % en poids, dans chaque cas par rapport au poids total des matières sèches de la composition sensible aux radiations.

**13.** Composition sensible aux radiations, travaillant en négatif, selon une ou plusieurs des revendications 1 à 12, caractérisée en ce que le composé réticulable b) est un résol.

**14.** Composition sensible aux radiations, travaillant en négatif, selon une ou plusieurs des revendications 1 à 13, caractérisée en ce que le composé réticulable b) est un composé aromatique substitué par un groupe alcoxyméthyle ou glycidyle, ou un produit de condensation mélamine/formaldéhyde ou urée/formaldéhyde.

**15.** Composition sensible aux radiations, travaillant en négatif, selon la revendication 1, caractérisée en ce que les 1-sulfonyloxy-2-pyridones présentent une plus forte absorption molaire, pour un rayonnement de longueur d'onde de 220 à 500 nm, que les autres composants du mélange.

**16.** Matériau de reprographie sensible aux radiations, travaillant en négatif, constitué d'un support et d'une couche sensible aux radiations, caractérisé en ce que la couche consiste en une composition sensible aux radiations selon les revendications 1 à 15.

**17.** Procédé pour la production d'un cliché caractérisé en ce que le matériau de reprographie selon la revendication 16 est irradié selon l'image, chauffé et ensuite développé, les zones non insolées du matériau étant dissoutes ou éliminées.

**18.** Procédé selon la revendication 17, caractérisé en ce que le matériau de reprographie est utilisé avec un rayonnement d'une longueur d'onde de 150 à 550 nm, de préférence de 200 à 450 nm, en particulier de 240 à 440 nm.